# EUROPEAN PATENT SPECIFICATION

(11) **EP 0 792 517 B1**
(45) Date of publication and mention of the grant of the patent: **22.10.2003**
(21) Application number: 95941408.7
(22) Date of filing: 13.11.1995
(51) Int. Cl.: H01R 9/00, H01R 29/00, H01R 12/20, B23K 31/02, H05K 3/30, H01L 23/49, H01L 21/60, H01L 23/48, H01L 23/498, H01L 21/66, H01L 21/68, H01L 23/32, H05K 3/24, C25D 5/16, H01L 21/603, H01L 21/607, H01L 23/538

(54) **ELECTRICAL CONTACT STRUCTURES FROM FLEXIBLE WIRE**
ELEKTRISCHE KONTAKTSTRUKTUR AUS FLEXIBLEM DRAHT
STRUCTURES DE CONTACT ELECTRIQUE OBTENUES PAR CONFIGURATION D'UN FIL SOUPLE

(30) Priority: 15.11.1994 US 340144; 26.05.1995 US 452255; 01.06.1995 US 457479; 21.09.1995 US 526246; 18.10.1995 US 533584; 09.11.1995 US 554902
(43) Date of publication of application: 03.09.1997
(60) Divisional application: 01127397.6
(73) Proprietor: FormFactor, Inc., Livermore, CA 94550 (US)
(72) Inventor: KHANDROS, Igor, Y., Orinda, CA 94563 (US); MATHIEU, Gaetan, L., Dublin, CA 94568 (US); ELDRIDGE, Benjamin, N., Hopewell Junction, NY 12533 (US); GRUBE, Gary, W., Monroe, NY 10950 (US)
(74) Representative: Käck, Jürgen
(86) International application number: US9514909
(87) International publication number: WO96017378

(56) References cited:
- EP-A- 0 002 166
- EP-A- 0 205 190
- EP-A- 0 396 248
- EP-A- 0 432 361
- EP-A- 0 500 074
- EP-A- 0 528 367
- EP-A- 0 593 966
- EP-A- 0 610 631
- EP-A- 0 642 163
- DE-A- 2 354 256
- DE-A- 2 618 867
- DE-A- 2 652 077
- DE-A- 3 129 568
- DE-A- 3 704 200
- DE-A- 4 232 745
- DE-B- 2 540 321
- DE-C- 3 744 099
- FR-A- 2 622 741
- FR-A- 2 643 753
- FR-A- 2 680 284
- US-A- 4 893 172
- US-A- 5 098 305
- US-A- 5 189 507
- US-A- 5 195 237
- "Bimetal VLSI Chip Interconnections" IBM TECHNICAL DISCLOSURE BULLETIN, vol. 29, no. 11, April 1987, NEW YORK US, pages 5021-5022, XP002040446
- PATENT ABSTRACTS OF JAPAN vol. 011, no. 092 (E-491), 24 March 1987 & JP 61 244057 A (NGK SPARK PLUG CO LTD), 30 October 1986,
- PATENT ABSTRACTS OF JAPAN vol. 011, no. 148 (E-506), 14 May 1987 & JP 61 287254 A (HITACHI DEVICE ENG CO LTD;OTHERS: 01), 17 December 1986,
- SHIH D -Y ET AL: "A NOVEL ELASTOMERIC CONNECTOR FOR PACKAGING INTERCONNECTIONS, TESTING AND BURN-IN APPLICATIONS" 21 May 1995 , PROCEEDINGS OF THE ELECTRONIC COMPONENTS AND TECHNOLOGY CONFERENCE, LAS VEGAS, MAY 21 - 24, 1995, NR. CONF. 45, PAGE(S) 126 - 133 , INSTITUTE OF ELECTRICAL AND ELECTRONICS ENGINEERS XP000624964 * the whole document *
- PATENT ABSTRACTS OF JAPAN vol. 009, no. 075 (E-306), 4 April 1985 & JP 59 211253 A (MATSUSHITA DENSHI KOGYO KK), 30 November 1984,
- PATENT ABSTRACTS OF JAPAN vol. 014, no. 187 (E-0917), 16 April 1990 & JP 02 034949 A (MATSUSHITA ELECTRIC IND CO LTD), 5 February 1990,
- PATENT ABSTRACTS OF JAPAN vol. 010, no. 213 (E-422), 25 July 1986 & JP 61 051838 A (HITACHI LTD), 14 March 1986,
- PATENT ABSTRACTS OF JAPAN vol. 011, no. 325 (E-551), 22 October 1987 & JP 62 113457 A (KYOCERA CORP), 25 May 1987,
- "METHOD OF TESTING CHIPS AND JOINING CHIPS TO SUBSTRATES" RESEARCH DISCLOSURE, no. 322, 1 February 1991, page 130 XP000169195
- MALINIAK D: "BARE-CHIP-ATTACHMENT METHOD SPREADS I/O, PERMITS PRETESTING" ELECTRONIC DESIGN, vol. 39, no. 10, 23 May 1991, page 32, 34 XP000234607
- PATENT ABSTRACTS OF JAPAN vol. 009, no. 248 (E-347), 4 October 1985 & JP 60 097655 A (HITACHI SEISAKUSHO KK), 31 May 1985,
- PATENT ABSTRACTS OF JAPAN vol. 011, no. 338 (E-553), 5 November 1987 & JP 62 120057 A (FURUKAWA ELECTRIC CO LTD:THE), 1 June 1987,
- PATENT ABSTRACTS OF JAPAN vol. 011, no. 312 (E-548), 12 October 1987 & JP 62 105459 A (HITACHI LTD), 15 May 1987,
- PATENT ABSTRACTS OF JAPAN vol. 011, no. 304 (E-545), 3 October 1987 & JP 62 097360 A (MITSUBISHI METAL CORP), 6 May 1987,
- PATENT ABSTRACTS OF JAPAN vol. 005, no. 070 (E-056), 12 May 1981 & JP 56 021354 A (TANAKA KIKINZOKU KOGYO KK;OTHERS: 01), 27 February 1981,
- PATENT ABSTRACTS OF JAPAN vol. 010, no. 095 (E-395), 12 April 1986 & JP 60 236252 A (FURUKAWA DENKI KOGYO KK), 25 November 1985,
- PATENT ABSTRACTS OF JAPAN vol. 006, no. 072 (E-105), 7 May 1982 & JP 57 012543 A (HITACHI LTD;OTHERS: 01), 22 January 1982,
- PATENT ABSTRACTS OF JAPAN vol. 009, no. 008 (E-289), 12 January 1985 & JP 59 155161 A (DAIICHI DENKOU KK), 4 September 1984,
- PATENT ABSTRACTS OF JAPAN vol. 010, no. 363 (E-461), 5 December 1986 & JP 61 160958 A (TOSHIBA CORP), 21 July 1986,
- PATENT ABSTRACTS OF JAPAN vol. 010, no. 376 (E-464), 13 December 1986 & JP 61 170054 A (MITSUBISHI ELECTRIC CORP), 31 July 1986,
- PATENT ABSTRACTS OF JAPAN vol. 011, no. 163 (C-424), 26 May 1987 & JP 61 291991 A (MATSUSHITA REFRIG CO), 22 December 1986,
- PATENT ABSTRACTS OF JAPAN vol. 004, no. 174 (C-033), 2 December 1980 & JP 55 113897 A (MITSUBISHI ELECTRIC CORP), 2 September 1980,
- PATENT ABSTRACTS OF JAPAN vol. 018, no. 022 (E-1490), 13 January 1994 & JP 05 259334 A (MITSUBISHI ELECTRIC CORP), 8 October 1993,
- PATENT ABSTRACTS OF JAPAN vol. 014, no. 455 (E-0985), 28 September 1990 & JP 02 183538 A (SEIKO EPSON CORP), 18 July 1990,
- PATENT ABSTRACTS OF JAPAN vol. 008, no. 066 (E-234), 28 March 1984 & JP 58 218131 A (MITSUBISHI DENKI KK), 19 December 1983,
- PATENT ABSTRACTS OF JAPAN vol. 006, no. 164 (E-127), 27 August 1982 & JP 57 084144 A (NEC CORP), 26 May 1982,
- PATENT ABSTRACTS OF JAPAN vol. 006, no. 077 (E-106), 14 May 1982 & JP 57 017141 A (TOSHIBA CORP), 28 January 1982,
- "METHOD FOR LARGE BOARD ENGINEERING CHANGES AND REPAIR" IBM TECHNICAL DISCLOSURE BULLETIN, vol. 37, no. 2B, 1 February 1994, pages 583-585, XP000433959
- "ENGINEERING CHANGE INTERPOSER" IBM TECHNICAL DISCLOSURE BULLETIN, vol. 37, no. 9, 1 September 1994, page 157 XP000473368

## Description

The invention relates to contact structures for making electrical connections to, from and between electronic components, especially microelectronic components and, more particularly, to contact structures exhibiting resiliency and/or compliance. In particular, the invention relates to contact structures including contact tip structures secured to resilient interconnect elements.

Due to its superior conductive and non-corrosive characteristics, gold is a "material of choice" for making electrical connections between electronic components. For example, it is well known to make a plurality of wire bond connections between conductive pads on a semiconductor die and inner ends of leadframe fingers. This is cited as one example of making permanent connections between a first, "active" electronic component (the die) and a second "passive" electronic component (the leadframe).

The present invention advantageously employs wire-bonding equipment in which, generally, wire (e.g., gold wire) is supplied from a spool through a capillary (also referred to as a "bonding head") and is bonded to a substrate. Generally, the nature of the bonding head will be determined by the nature of the bond to be made thereby. When the bonding head is for making a ball bond, it will generally be a "capillary". When the bonding head is for making a wedge bond, it will generally be a "wedge", these terms having recognized meanings in the art. To simplify matters, in the main hereinafter, the term "capillary" will be employed to indicate a bonding head suitable for making either ball or wedge bonds, applying thermal energy and/or compression during bonding.

The following US patents (cited, when applicable, by patent number, first named inventor, month/year of issue, and US Class/Subclass), are indicative of the state of the art of wirebonding:

U.S. Patent No. 5,110,032, discloses wire (13) supplied from a wire spool (12) through a capillary (10). (In this patent, the wire 13 is insulated.) A control unit (20) is shown which includes a CPU (processor) and a memory unit (storage for software commands). The control unit exercises control over movement of the capillary, and over a discharge power circuit (18) which, in conjunction with a discharging electrode (17) is used to sever the wire with a discharge voltage.

Pins, i.e. elongated rigid electrically-conductive elements, are well known, and are generally brazed to pads on electronic packages (including chip carriers).

U.S. Patent No. 3,373,481, discloses forming pin-like gold pedestal structures (13) atop terminal portions (12) of an integrated circuit device (10) by thermocompressing gold spheres (13) and shaping the spheres with a heated vacuum holder (14).

U.S. Patent No. 4,418,857 , discloses an exemplary technique for brazing pins to chip carrying substrates.

U.S. Patent No. 4,955,523, discloses a technique for interconnecting electronic components in which interconnection wires are bonded to contacts on a first component (such as a semiconductor die (1)) without the use of a material other than the materials of the contacts and the wires.

Another illustrative effort at making resilient connections may be found in U.S. Patent No. 5,299,939, which discloses independently bendable springs with significant horizontal elasticity, including sine, helix, cantilever, and buckling beam shapes in sheet and wire forms.

U.S. Patent No. 4,793,814, discloses a connector arrangement for providing electrical interconnection between corresponding contact pads of opposed first and second circuit boards and includes an electrically nonconductive support member which includes resilient elastomeric material.

Generally, each of the aforementioned and other techniques for effecting electrical connections between electronic components requires its own "methodology" - in other words, each requires its own distinct type (e.g., bond wires, pins, etc.) of connection structure.

Moreover, each of the aforementioned techniques suffers from inherent limitations. For example, replacing a first electronic component that is permanently connected to a second electronic component typically requires carefully un-soldering the first electronic component from the second electronic component, then carefully soldering a replacement first electronic component to the second electronic component. Sockets address this concern, but add (often unacceptable) cost to the overall system. Moreover, socketing tends to exhibit inferior connection reliability, as contrasted with soldered connections. Surface mount techniques, such as the aforementioned technique of providing the first electronic component with solder balls and providing the second electronic component with conductive pads require carefully controlled processes to effect reliably, and do not lend themselves well to disassembly (replacement of one of the electronic components).

Returning to the popularity of using gold to make connections between electronic components, although gold exhibits excellent electrical conductivity, it suffers from certain shortcomings, as relevant to the present invention. For example, gold has a very low yield strength, a characteristic which makes it extremely counter-intuitive to employ a gold wire in (or as) a resilient contact structure. Simply stated, when physically stressed, gold (e.g., a gold wire) will tend to deform, and to retain its deformed configuration. This is called "plastic deformation".

Another shortcoming of using gold wires as an interconnect medium is gold's propensity to react with solder - namely with the tin content of common lead-tin solder. Notwithstanding this fact, certain "eutectic" materials are known, such as gold-tin, which tend to exhibit desireable interconnection properties. Eutectic materials and their properties are discussed in greater detail hereinbelow.

EP-A- 0 396 248, representing the closest prior art, discloses a method of installing a plurality of electrical pin members onto a substrate. In this method, a solder layer is preformed on each junction point on a printed circuit board of an IC chip ceramic substrate. The junction points having the solder layer are aligned with the particular arrangement of the pin members supported on a ceramic plate (sacrificial substrate). The pin members and the junction points on the ceramic substrate are aligned in such a manner that each pin element is pressed on the solder layer at each junction point. The solder layers are heated, thereby making solder electrical connections of the pin elements to respective junction points. In a final step, the ceramic plate supporting the pin elements is removed. Consequently, the pin elements are firmly mounted and electrically connected to the respective junction points on the ceramic substrate at their bottom ends while the upper ends are ready to receive electrodes of an IC chip device.

The present invention provides an improved contact mechanism for connecting two electronic components. Using a basic resilient interconnection element, as described in related patents, provides a springy interconnect, which allows an electronic component with an attached interconnection element to contact another electronic component. The resilient interconnection provides a number of mechanical advantages. The present invention improves this resilient interconnection element by forming a contact tip structure then joining this to the interconnection element. In the finished product, this contact tip structure is at the interface to the second electronic component.

The present invention benefits further from making a contact tip structure that includes a topography, that is, is not just a flat pad. In particular, it is advantageous to form one or more pointed features on the contact tip structure. This is conveniently made by starting with a sacrificial substrate, forming one or more depressions in the sacrificial substrate, as by stamping or etching, then forming the contact tip structure on the sacrificial substrate, filling the depressions. The resilient contact element is secured to the contact tip structure, and the sacrificial substrate is removed.

The contact tip structure described herein is useful with a variety of support members. In particular, a resilient contact element is described but one skilled in the art will appreciate other support members to which a contact tip structure can be secured.

It is a general object of the present invention to provide improved techniques for interconnecting electronic components, especially microelectronic components.

It is another object of the present invention to provide improved techniques for mounting contact structures to electronic components, especially semiconductor dies.

It is another object of the present invention to provide improved techniques for making electronic assemblies.

These objects are solved by the features described in claim 1.

More particular, a method of mounting a plurality of contact structures to an electronic component comprises the following steps: fabricating a plurality of resilient electrical contact structures on a sacrificial substrate by forming the electrical contact structures from a flexible core material and overcoating the core material with a material being more resilient than said core material; bringing the sacrificial substrate into proximity with an electronic component so that the tips of the electrical contact structures extending from the sacrificial substrate contact the electronic component; in a single step, mounting the electrical contact structures by their tips to the electronic component; and after mounting the electrical contact structures to the electronic component, removing the sacrificial substrate.

Particular embodiments of the inventive method are defined in the dependent claims 2 to 24.

A resulting resilient and/or compliant (springy) contact structure is thereby formed which is securely mounted to the electronic component and which may be used for effecting temporary and/or permanent connections of the electronic component to another electronic component, or which may be used to effect permanent (e.g., soldered) connections of the electronic component to another electronic component.

Generally, as used herein, compliance encompasses resilience (elastic deformation) and flexibility (plastic deformation). In some instances, both plastic and elastic deformation are desired. In other instances (such as contact structures used for probes), elastic deformation only is desired, but some plasticity may be acceptable. In other instances, true springs, exhibiting purely elastic deformation, are not desired, as they would impose too high of a load upon the substrate whereupon they are mounted. In other instances (such as contact structures on interposers), pure plasticity may be desired to accommodate non-planarity. The present invention permits tailoring the plastic and elastic deformation of a contact structure to the application (e.g., load conditions) for which it is intended.

In an exemplary embodiment of the invention, the falsework (wire stem) is a gold wire having a diameter in the range of 1.8 to 50.5 µm (0.0007-0.0020 inches), and the superstructure (overcoat) is a nickel plating having a thickness in the range of 2,54 to 254 µm (0.0001 - 0.0100 inches).

According to the invention, a plurality of resilient contact structures are mounted to an electronic component having a plurality of contact areas. For example, up to hundreds of resilient contact structures can be mounted to a semiconductor die or to a semiconductor package having up to hundreds of bond pads or package pads, respectively.

The free-standing wire stem is overcoated (e.g., plated) with a conductive, metallic material that serves two principal purposes:
(a) it is a springy (resilient) material such as nickel, so that the resulting overcoated wire stem (contact structure) can behave as a spring; and
(b) it covers the terminal (or pad, or the like) to firmly anchor the wire stem (and the resilient contact structure) to the terminal.

Various applications for contact structures fabricated according to the techniques of the present invention are described, including mounting the contact structures to semiconductor dies, packages, PCBs, etc. The use of resilient contact structures as probes is also described. Bonding the wire stem to a sacrificial element (or member, or structure) is also described. Multi-layer coatings over the wire stem are also described.

Other objects, features and advantages of the invention will become apparent in light of the following detailed description thereof.

Reference will now be made in detail to preferred embodiments of the invention, examples of which are illustrated in the accompanying drawings. Although the invention will be described in the context of these preferred embodiments, it should be understood that it is not intended to limit the spirit and scope of the invention to these particular embodiments.
**Figure 1** is a perspective view of a supply wire having its free (proximal) end bonded to a substrate by a bonding head (capillary) of a wirebonder, according to the prior art.
**Figures 1A to 3D** are shown for illustrative purposes, wherein:

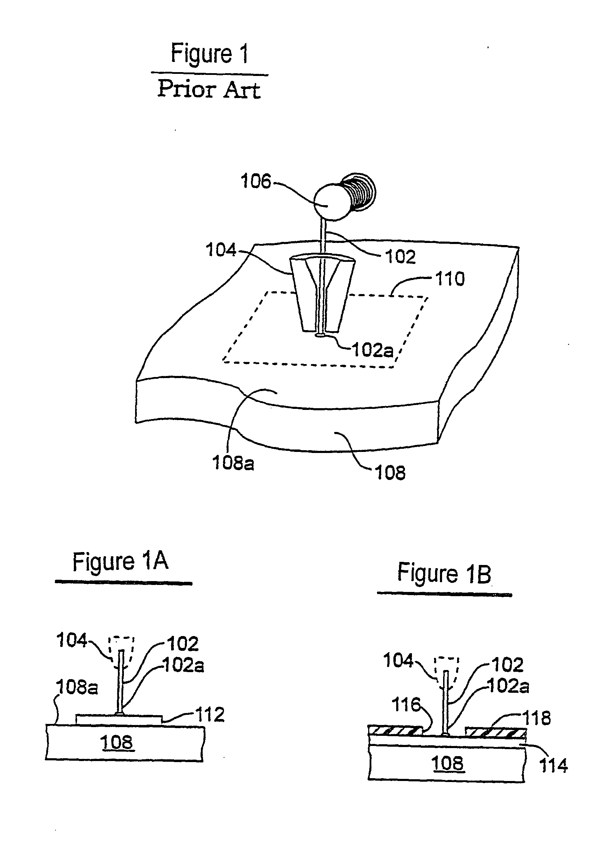

   **Figure 1A** is a side view of a wire having its free end bonded to a terminal on a substrate.
   **Figure 1B** is a side view of a wire having its free end bonded to a substrate, through an opening in a photoresist layer.

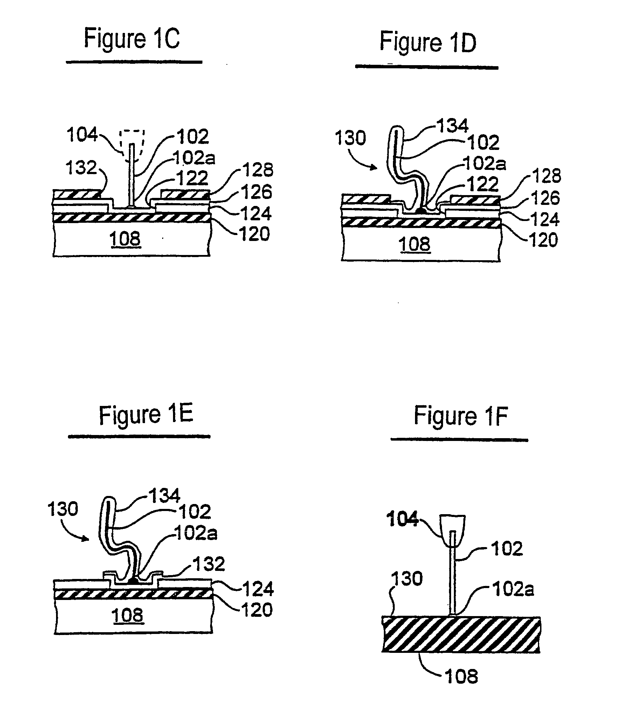

   **Figure 1C** is a side view of a wire having its free end bonded to a metal layer applied to a substrate, through an opening in a photoresist layer.
   **Figure 1D** is a side view of the substrate of **Figure 1C,** with the wire overcoated.
   **Figure 1E** is a side view of the substrate of **Figure 1D,** with the photoresist layer removed and the metal layer partially removed.
   **Figure 1F** is a side view of a wire having its free end bonded to substrate, which may be a sacrificial substrate, according to the prior art.

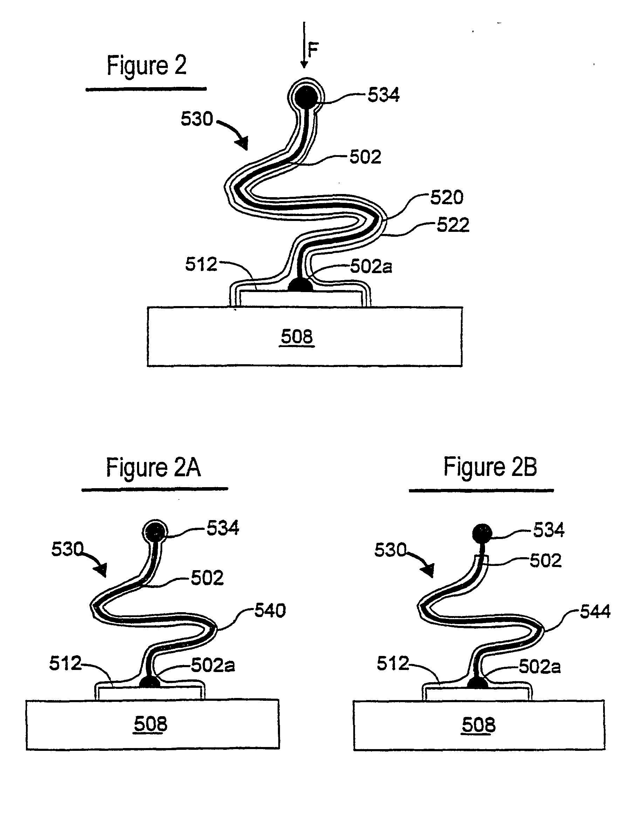

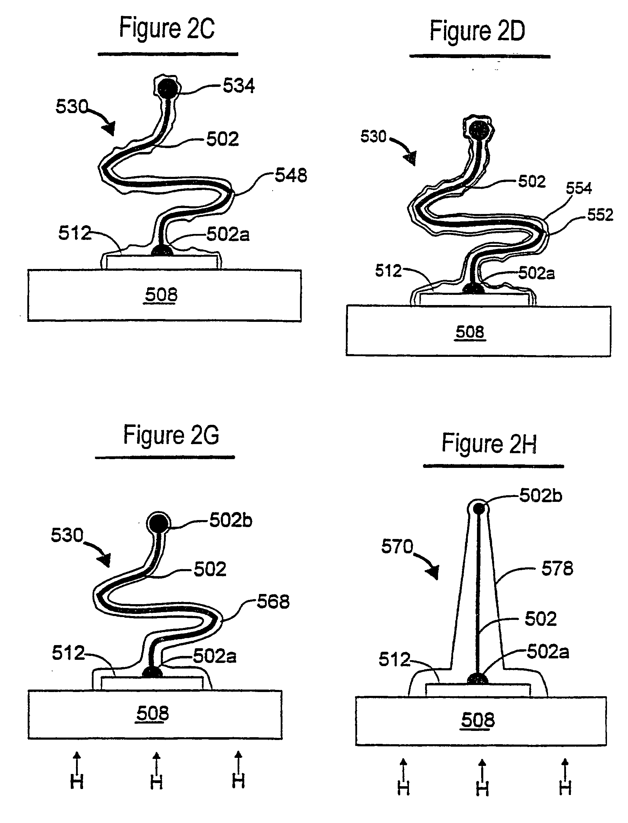

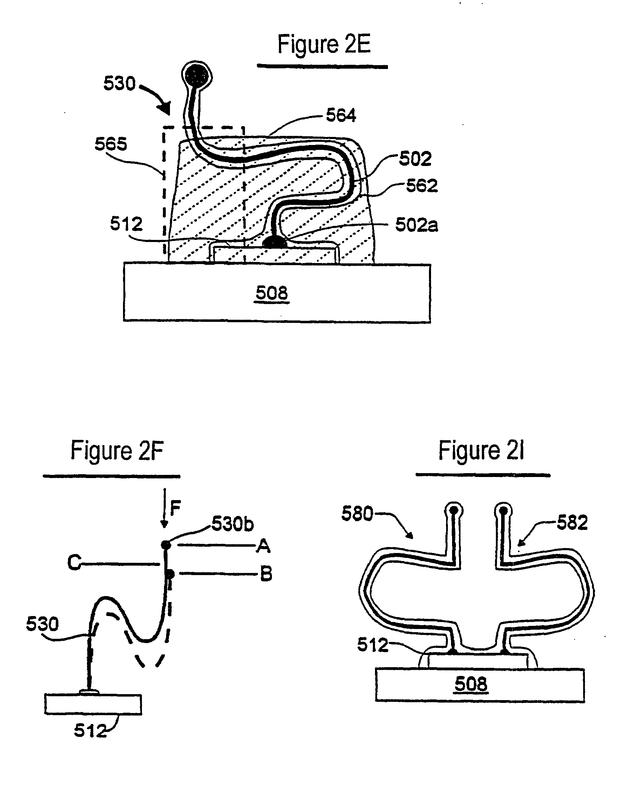

   **Figure 2** is a side view of a wire which has been configured to have a shape, and which has been overcoated with multiple (at least two) layers of material to create a resilient contact structure.
   **Figure 2A** is a side view of a wire which has been configured to have a "springable" shape (a shape which will determine a configuration), and which has been fully overcoated ("enveloped") with a single layer of material to create a resilient contact structure.
   **Figure 2B** is a side view of a wire which has been configured to have a springable shape, and which has been partially overcoated ("jacketed") with a single layer of material to create a resilient contact structure.
   **Figure 2C** is a side view of a wire which has been configured to have a springable shape, and which has been fully overcoated ("enveloped") with a single layer of material to create a resilient contact structure having microprotrusions on its surface .
   **Figure 2D** is a side view of a wire which has been configured to have a springable shape, and which has been fully overcoated ("enveloped") with multiple (at least two) layer of material to create a resilient contact structure having microprotrusions on its surface.
   **Figure 2E** is a side view of a wire which has been configured to have a springable shape, and which has been fully overcoated ("enveloped") with a layer of material, and which has further been embedded in a compliant electrically-conducting material, such as an elastomer material.
   **Figure 2F** is a schematic illustration of an exemplary resilient contact structure configured into a springable shape and overcoated (overcoating omitted from this figure) showing the ability of the contact structure to deflect in response to an applied deflecting force (F).
   **Figure 2G** is a side view of a wire which has been configured to have a springable shape, and which has been fully overcoated ("enveloped") with at least one coating, in conjunction with applying heat during the overcoat (e.g., plating) process.
   **Figure 2H** is a side view of a wire which has been configured to have a straight, pin-like shape, and which has been fully overcoated ("enveloped") with at least one coating, in conjunction with applying heat during the overcoat (e.g., plating) process.
   **Figure 2I** is a side view of an embodiment wherein two wire stems are mounted to a single terminal and overcoated.

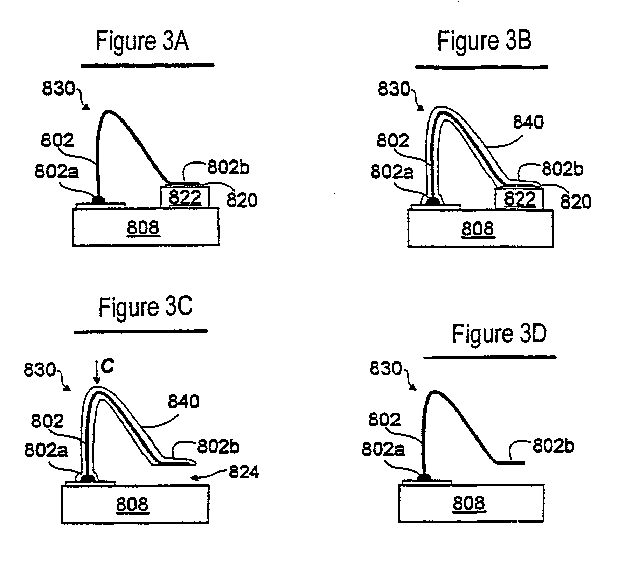

   **Figure 3A** is a side view of a wire configured into a loop, with the distal end of the wire bonded to a sacrificial element.
   **Figure 3B** is a side view of the looped wire of **Figure 3A** after being overcoated.
   **Figure 3C** is a side view of the looped, overcoated wire of **Figure 3B** after the sacrificial element has been removed.
   **Figure 3D** is a side view of the looped wire of **Figure 3A** after the sacrificial element has been removed, but before the wire has been overcoated.

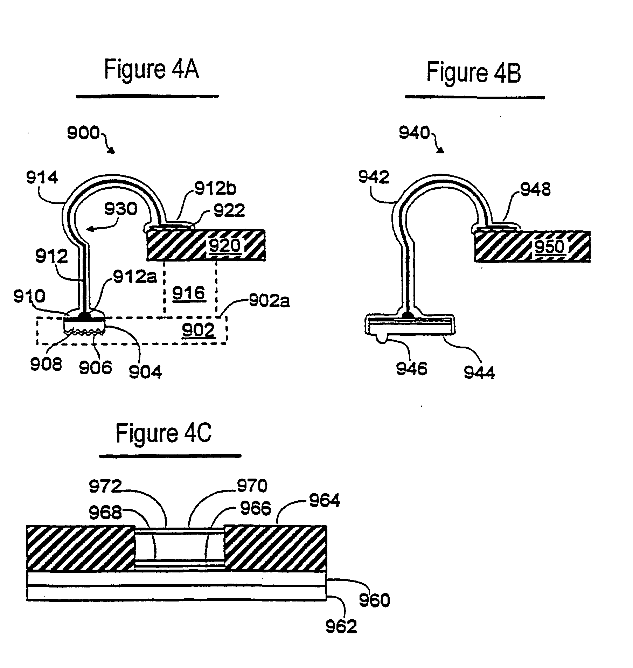

**Figure 4A** is a side view of a wire configured into a shape and overcoated, in an embodiment of a resilient probe, according to the present invention.
**Figure 4B** is a side view of a wire configured into a shape and overcoated in an alternate embodiment of a resilient probe, according to the present invention.
**Figure 4C** is a side view of a multilayer contact pad for a resilient contact structure, according to the present invention.

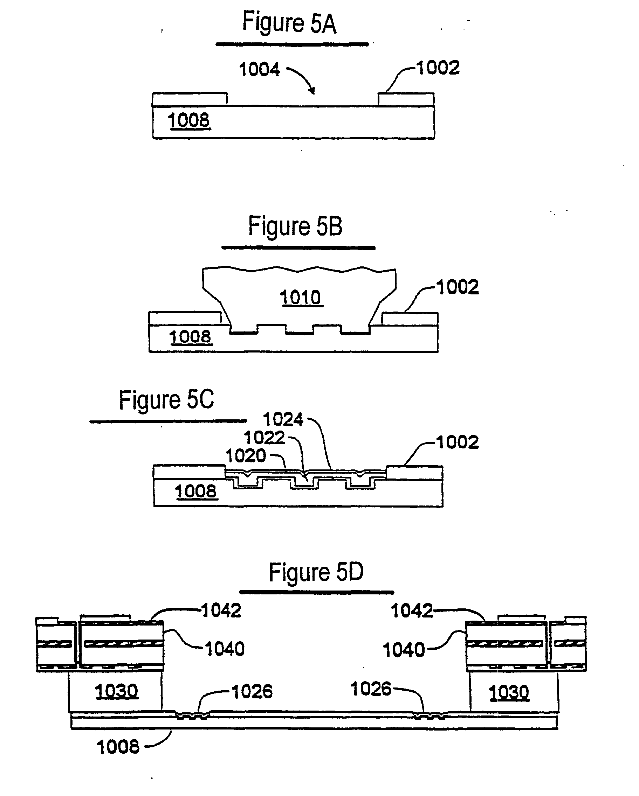

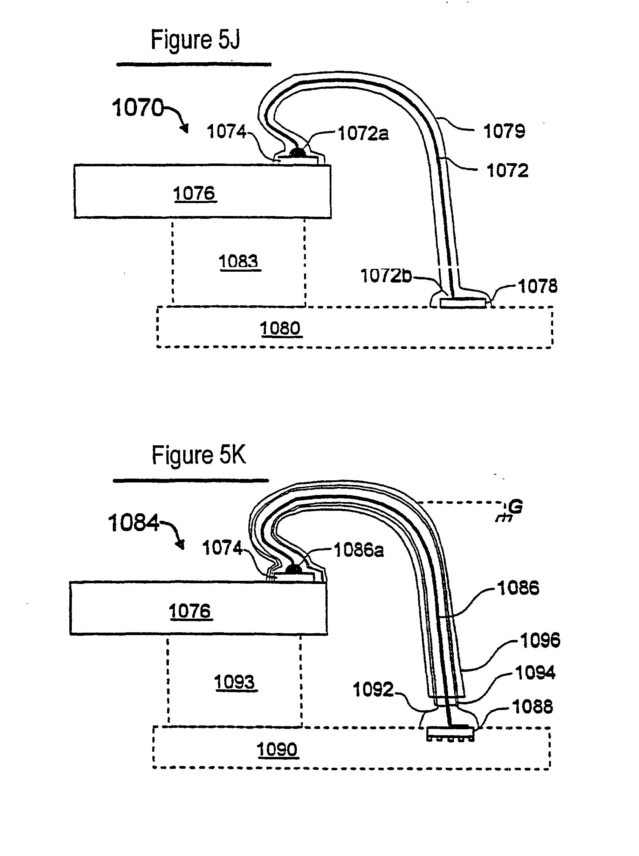

**Figures 5A-5C** are side views of a first phase (Phase-1) of a process for forming a chip-probing card having resilient contacts, according to the present invention.
**Figures 5D-5G** are side views of a second phase (Phase-2) of a process for forming a chip-probing card having resilient contacts, according to the present invention.

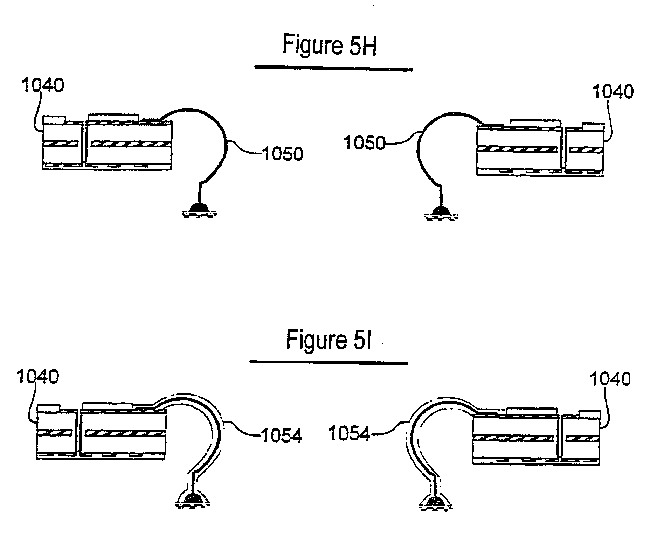

**Figures 5H-5I** are side views of an alternate embodiment of a second phase (Phase-2) of a process for forming a chip-probing card having resilient contacts, according to the present invention.
**Figure 5J** is a side view of an embodiment of a wire configured and overcoated to function as a probe, according to the present invention.
**Figure 5K** is a side view of another embodiment of a wire configured and overcoated to function as a probe, according to the present invention.

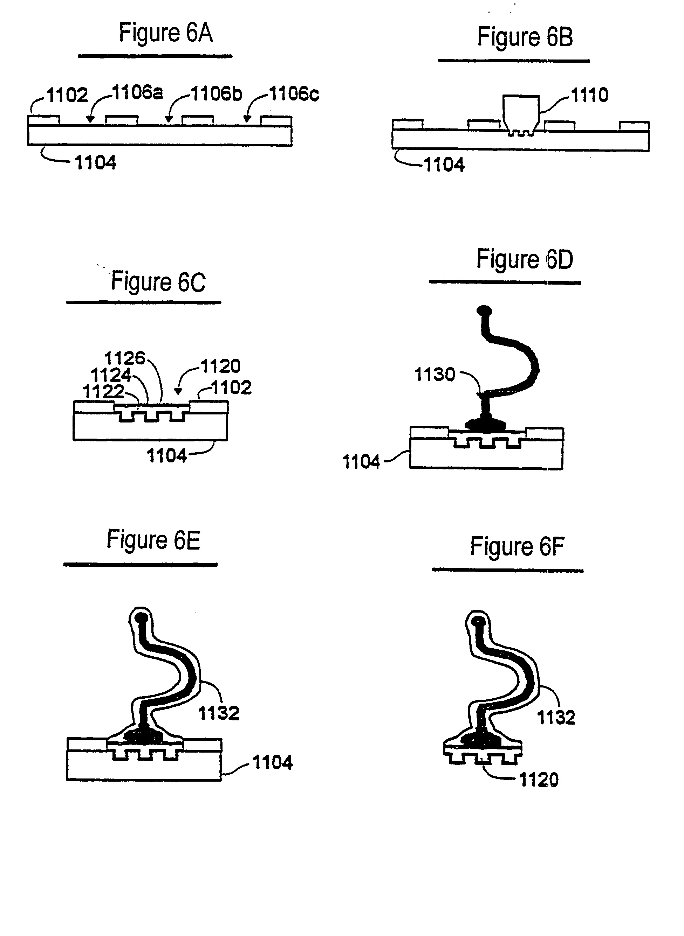

**Figures 6A-6F** are side views illustrating a process sequence for mounting resilient contact structures to a sacrificial substrate, according to the present invention.

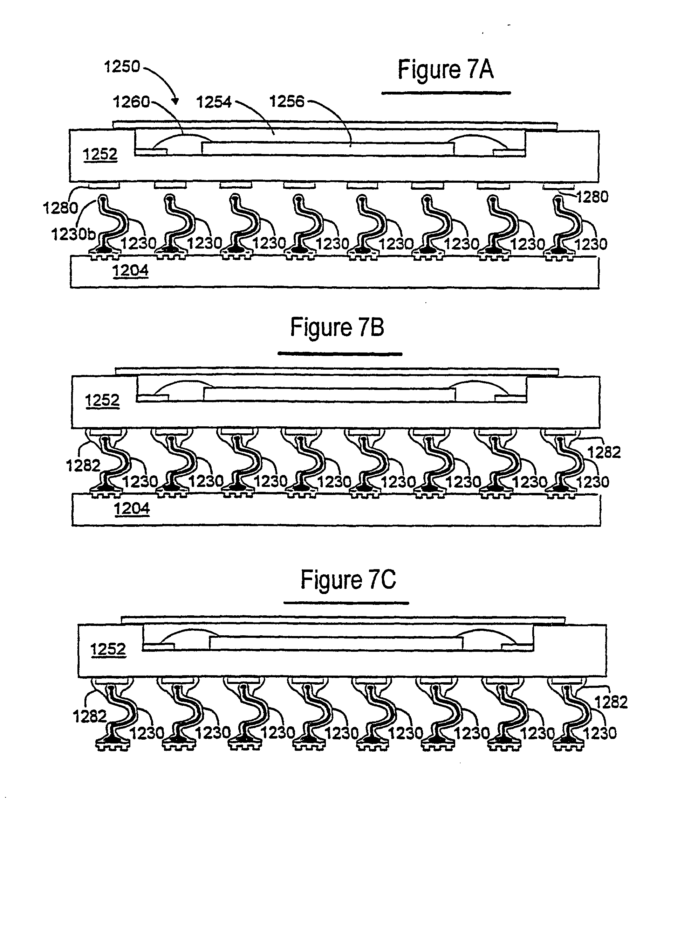

**Figures 7A-7C** are side views of a "gang transfer" technique for mounting resilient contact structures to an external surface of a semiconductor package, according to the present invention.

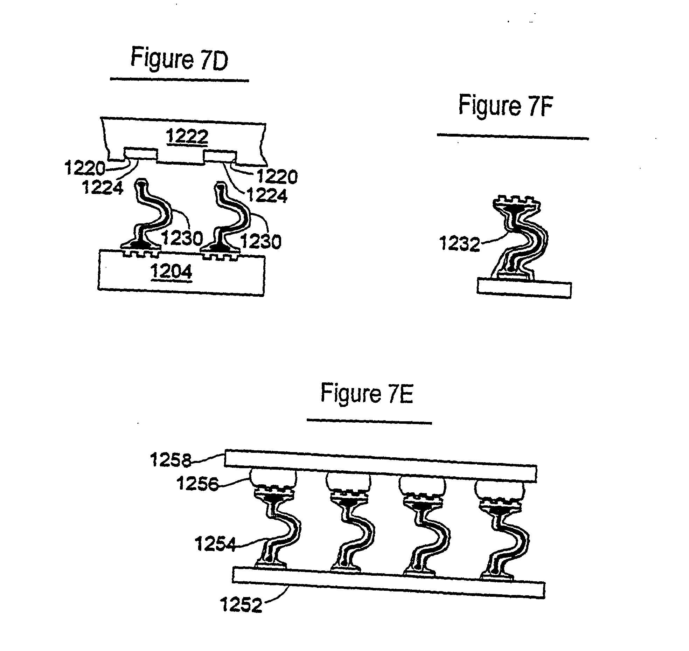

**Figure 7D** is a side view of a technique for mounting resilient contact structures to recesses in a surface of a semiconductor package, according to the present invention.
**Figure 7E** is a side view of a technique for making a probe card, according to the present invention.
**Figure 7F** is a side view of a technique for disposing an outer layer on a resilient contact structure, such as to make it more secure on the substrate to which it is mounted, according to the present invention.

In the side views presented herein, often portions of the side view are presented in cross-section, for illustrative clarity. For example, in many of the views, the wire stem is shown full, as a bold line, while the overcoat is shown in true cross-section (often without crosshatching).

In the figures presented herein, the size of certain elements are often exaggerated (not to scale, vis-a-vis other elements in the figure), for illustrative clarity.

In the figures presented herein, elements are often numbered with the Figure number as a "prefix", and the "suffixes" often refer to similar elements.

This invention expands on the inventions disclosed in U.S. Patent No. 5,476,211, (referred to hereinafter as "CASE-1") and WO 95/14314 (referred to hereinafter as "CASE-2"),

**Figure 1**, similar to Figure 1 of CASE-1, shows a wire 102 feeding through a capillary 104 (shown in cross-section) of a wirebonder. The wire 102 is fed to the capillary from a spool 106. The capillary 104 is brought towards a surface 108a of a substrate 108, so that the free end 102a of the wire 102 contacts the surface 108a of the substrate 108 and is bonded in any suitable manner thereto. Bonding a free end of a wire to a surface of a substrate is well known, and requires no further elaboration.

As shown in **Figure 1**, the free end 102a of the wire 102 is bonded to the surface 108a of the substrate within an arbitrarily defined "**contact area**" 110 (shown in dashed lines). This contact area 110 may be of any shape (rectangular shown, can be circular or any other arbitrary shape), and is notably larger than and encompasses (subsumes) the location (relatively small area) whereat the free, bonded end 102a of the wire 102 is bonded to the surface 108a of the substrate 108.

As will be discussed in greater detail hereinbelow, the bonded end 102a of the wire 102 will, in many embodiments that follow, become the **"proximal end"** of a resulting **"wire stem".**

**Figure 1A** shows that the free end 102a of the wire 102 may be bonded to a conductive terminal 112 on the surface 108a of the substrate 108. The formation of a conductive terminal (or "pad", or "bond pad") on a surface of a substrate, and bonding a wire thereto is well known. In this case, the terminal 112 constitutes (defines) the contact area 110 (see **Figure 1**). In **Figure 1A**, the capillary 104 is shown in dashed lines, and is stylized.

**Figure 1B** shows that the free end 102a of the wire 102 may be bonded to a metal (conductive) layer 114 on a (typically non-conductive, or semiconductive) substrate 108, through an opening 116 etched in an overlying layer of photoresist 118. In this case, the opening 116 in the photoresist constitutes the contact area 110 (see **Figure 1**). In **Figure 1B**, the capillary 104 is shown in dashed lines, and is stylized.

**Figures 1C, 1D and 1E** show a technique for bonding the free end 102a of the wire 102 to a surface of a substrate 108, which is a preferred technique for bonding the wire 102 to semiconductor substrates. In **Figure 1C**, the capillary 104 is shown in dashed lines, and is stylized. In **Figure 1C** it is shown that the conductive layer 120 is (as in **Figure 1B**) disposed on the top surface of the substrate 108. This layer 120 may be a top metal layer, which is normally intended for bond-out to the die, as defined by openings 122 in a passivation layer 124 (typically nitride). In this manner, a bond pad would be defined which would have an area corresponding to the area of the opening 122 in the passivation layer 124. Normally (i.e., according to the prior art), a wire would be bonded to the bond pad.

A blanket layer 126 of metal material (e.g., aluminum) is deposited over the passivation layer 124 in a manner that the conductive layer 126 conformally follows the topography of the layer 124, including "dipping" into the opening 122 and electrically contacting the layer 120. A patterned layer 128 of photoresist is applied over the layer 126 with openings 132 aligned over the openings 122 in the passivation layer 124. An important feature of this technique is that the opening 132 is larger than the opening 122. As will be evident, this will result in a larger bond area (defined by the opening 132) than is otherwise (as defined by the opening 122) present on the semiconductor die (108). The free end 102a of the wire 102 is bonded to the top (as viewed) surface of the conductive layer 126, within the opening 132. After the wire is configured to have a shape and is severed to create a "wire stem", the wire stem is overcoated (as described hereinbelow with respect to **Figures 2, 2A-2F**). (For purposes of this discussion, an overcoated wire stem is a termed a "resilient contact structure" 130.) This is shown, in a general exemplary manner, in **Figure 1D**, wherein it can be seen that a material 134 overcoating the wire stem (i.e., the shaped wire 102 which is shown in **Figures 1D and 1E** as a thick solid line) completely envelops the wire stem and also covers the conductive layer 126 within the area defined by the opening 132 in the photoresist 128. The photoresist 128 is then removed (such as by chemical etching, or washing), and the substrate is subjected to selective etching (e.g., chemical etching) to remove all of the material from the conductive layer 126 except that portion of the layer 126 which is covered by the material 134 overcoating the wire stem. This results in the structure shown in **Figure 1E,** a significant advantage of which is that the contact structure 130 is securely anchored (by the coating material 134) to an area (which was defined by the opening 132 in the photoresist) which can easily be made to be larger than what would otherwise (e.g., in the prior art) be considered to be the contact area of a bond pad (i.e., the opening 122 in the passivation layer 124). In this case, the area defined by the opening 132 in the photoresist 128 is the contact area (110).

**Figure 1F** shows that the free end 102a of the wire 102 may be bonded to a conductive (e.g., metallic, as indicated by single line cross-hatching) substrate 108 which, as will be discussed in greater detail hereinafter, may be a sacrificial substrate (e.g., a substrate that is dissolved away after bonding the wire thereto). In this case, the contact area 110 is not shown, but is arbitrarily defined in the manner indicated in **Figure 1**. In **Figure 1F**, the capillary 104 is shown in dashed lines, and is stylized.

In all of the cases set forth above (**Figures 1, 1A, 1B, 1C-1E, 1F**), which cases are intended to be exemplary and not limiting, the free end (102a) of the wire (102) is bonded within a defined area (110) on a substrate. However, as is readily apparent from the drawings, the bond (of the proximal end of the wire) itself occupies a relatively small area within the defined area (110). By way of example, the small area of the bond itself may be only 5-50% of the overall area of the contact area 110, and is preferably not at an edge of the contact area, but is preferably more-or-less centered within the contact area.

As is discussed hereinbelow, the wire stem will be overcoated with a material that imparts resiliency thereto, and that anchors itself to the entire contact area.

The wire is an elongate element of a size and of a material that is easily fabricated into a shape (i.e., "**flexible**"), as discussed hereinbelow. As will become evident, it is not of particular importance to the present invention that wire is capable of conducting electricity between two electronic components since, the wire will (in most of the embodiments described hereinbelow) be entirely overcoated with a conductive material. However, it is certainly within the scope of this invention that the wire is made of a material that is conductive.

Generally, according to the present invention, the "existential" properties of the wire (i.e., its ability to be shaped and overcoated) tend to overshadow its structural or electrical properties. Moreover, once the wire stem is overcoated with a resilient, electrically-conductive material, the wire stem becomes largely superfluous.

An exemplary material for the wire is gold, in the form of a round (cross-section) wire, having a diameter (thickness) of approximately 25 µm (0.0010 inches). This includes, but is not limited to diameters in the range of 20 - 50 µm. The wire is preferably in the range of 0.0005 to 0.0030 inches (12 - 75 µm). Such a wire will be very formable (into a desired shape), is an excellent electrical conductor, is very available, and exhibits good long term resistance to corrosion.

Gold wire is readily available from several suppliers, n a variety of sizes (e.g., 25 µm (0.001 inch), diameter) and compositions. For example:
- 99.99% gold, plus beryllium;
- 99.99% gold, plus copper;
- 1% silicon aluminum alloy; and
- 1% magnesium aluminum alloy.

Copper wire, preferably as pure as possible, is also readily available and suitable for use as the wire stem of the present invention.

Other (than gold) suitable materials for the wire, for which a similar range of diameters would be applicable, include:
aluminum;
copper alloyed with small amounts of other metals to obtain desired physical properties, such as with beryllium, cadmium, silicon and magnesium;
gold, copper or aluminum alloyed with materials such as lead, tin, indium, cadmium, antimony, bismuth, beryllium and magnesium;
silver, palladium, platinum;
metals or alloys such as metals of the platinum group; and
lead, tin, indium and their alloys.

Generally, a wire of any material that is amenable to bonding (using temperature, pressure and/or ultrasonic energy to effect the bonding) would be suitable for practicing the invention.

Preferably, the material of the wire is gold, aluminum, copper, or their alloys. For example:
1. Gold, doped (alloyed) with Beryllium (e.g., less than 12 ppm, preferably 5-7 ppm) or Cadmium
2. Aluminum doped with Silicon or Magnesium, alternatively with Silver or Copper
3. Platinum/Palladium mixed with Copper/Silver

As will be discussed in greater detail hereinbelow, in many of the embodiments described herein, the wire is severed to have a distal end and a length. The wire may have any desired length, but typically would have a length commensurate with its use in conjunction with small geometry semiconductor devices and packages, wherein its length would be: 0.2-13 mm (0.010 inches to 0.500 inches).

The wire need not have a circular cross-section, although such is preferred. The wire may have a rectangular cross-section, or may have a cross-section of yet another shape.

Traditional wirebonding requires robust bonds to be made at both ends of a wirebond loop to avoid, inter alia, de-cohesion. Bond strength is of paramount importance, and process constraints are relatively very rigid.

According to the present invention, the constraints for bonding a wire stem to a substrate are greatly relaxed (e.g., vis-a-vis traditional wirebonding). Generally, so long as the wire stem stays in place during shaping and overcoating, the bond strength is "sufficient". This also accounts for the wide variety of wire materials set forth hereinabove, the material generally being chosen for properties other than the robustness of a bond formed therewith.

Once the free (proximal) end (102a) of the wire (102) has been bonded to the substrate (108), the capillary (104) is moved generally upward (in a z-axis direction) from the surface of the substrate and the substrate, which typically is mounted to an x-y table (not shown) is moved in the x- and y-directions. This imparts a relative motion between the capillary and the substrate which, in the main hereinafter, is described as the capillary being moved in three axes (x-axis, y-axis, z-axis). As the capillary moves, the wire "plays out" of the end of the capillary.

According to the invention, the relative motion between the capillary and the substrate is controlled, and imparts a desired shape to the wire.

In typical wirebonding operations, a free end of a wire is bonded (e.g., to a bond pad on a semiconductor die), the capillary moves up (to a prescribed height above the surface of the substrate), the substrate moves over (typically it is the substrate that is moved to impart relative motion in the x-y plane between the substrate and the capillary), and the capillary is moved back down (e.g., onto a bonding location on conductive traces of a leadframe, a semiconductor package, or the like). The wire plays out of the capillary during this relative movement of the capillary. Although this (e.g., up/over/down) movement of the capillary (in the prior art) imparts a generally arcuate "shape" to the wire (even a straight wire can be considered to have a "shape"), the "shaping" of the present invention is quite different.

As will be quite evident, the wire stem is shaped so that a contact structure comprising a wire stem that is overcoated, such as by plating, functions as a resilient contact structure.

With this in mind, it is evident that the concept of "shaping" the wire, according to the present invention, is entirely different from any incidental (i.e., not intended to establish a resulting resilient contact structure) "shaping" of the prior art. As used herein, the concept of "shaping" the wire differs dramatically from the shaping of the prior art in the manner in which the wire is shaped, both in the underlying purpose of shaping the wire, and in the resulting geometry of the wire shape.

As will be discussed in greater detail hereinbelow, once the proximal end of the wire is bonded to the substrate, it is advertently (versus incidentally) "formed", "fashioned", or configured to have a definite, desirable geometric form which will serve as a what has been referred to in the parent cases as a "skeleton" for establishing the physical configuration of a subsequent coating over the wire which will conform to the shape of the wire and which will impart resiliency to a subsequent contact structure of the coated wire (other advantages of the coating, in addition to imparting resiliency to the shaped wire stem, are described hereinbelow). Hence, when the terms "configuring", "fashioning", "forming", "shaping" and the like, as used herein, they are specifically intended to be interpreted as having a meaning which describes the ability of the wire to establish a resulting configuration for a coating which will impart resiliency (springiness) to the resulting contact structure (coated wire).

Upon reading this patent application, one having ordinary skill in the art to which the present invention most nearly pertains will understand that once shaped and overcoated, the wire stem itself is essentially superfluous - the overcoat material providing the requisite electrical conductivity and desired mechanical characteristic of the resulting resilient contact structure. However, as will be evident, in certain embodiments of the invention, it is required that the wire stem is electrically conductive, since electrical contact will be made thereto.

In a sense, the wire stem of the present invention functions in a manner analogous to a "**falsework**" a temporary scaffolding or support used in construction to establish the resulting shape of stone or brick arches. As a corollary to this analogy, the overcoat can be considered to function as a "**superstructure**".

In another sense, the wire stem functions in a manner analogous to a "**mandrel**" - a core around which other materials may be shaped.

In yet another sense, the wire stem functions as a "**template**" - a pattern or model for an item being made or synthesized.

It is understood that these analogies are not perfect, in that falseworks, mandrels and templates are typically removed after serving their intended purpose. In the case of the wire stem of the present invention, it is not necessary to remove the wire stem it is overcoated, although embodiments wherein the wire stem is removed are disclosed.

Perhaps a more apt analogy is that the wire stem serves as an "**outline**", in the manner that an outline can be created prior to writing a book. The outline describes what the book is "going to be", and may be included in the book, or it can be discarded after the book is written. In either case, the outline establishes the resulting form of the book.

In the parent cases, the shaped wire stem was referred to as a "**skeleton**" - a supporting structure or framework. This too is a useful choice of terms, in that a skeleton typically remains in place. Like the human skeleton (framework of bones) which determines the shape of the overlying tissue, the wire stem of the present invention establishes the shape of the resulting contact structure. However, unlike the human skeleton which must remain in place in order for the overlying tissue to perform its intended function, and which contributes significantly to the "mechanical" characteristics of the human body, the wire stem of the present invention need not remain in place in order for the overlying material coating to perform its intended function, and the wire stem does not contribute significantly to the mechanical characteristics of the resulting contact structure.

One of the significant advantages of using a readily-deformable, malleable, compliant material for the wire stem is that it is readily configured to establish a shape for the overcoat applied thereto, without significantly altering the physical properties (e.g., tensile strength, resiliency, etc.) of the resulting resilient contact structure. Inasmuch as the wire stem serves as an important first step in the overall process (begun, but not completed) of fabricating a resulting contact structure, the wire stem can be characterized as an "inchoate" contact structure.

Since the present invention is primarily targeted at fabricating resilient contact structures for interconnecting electronic components such as semiconductor dies, said resilient contact structures, in many cases, being barely visible to the naked eye, the contribution and configuration of the wire stem can more easily be visualized by taking a length (e.g., a 15,24 cm (six inch) length) of malleable wire (such as 14 gauge copper wire, or comparable gauge lead-tin solder wire), mounting a one end of the wire in a hole in a wooden block, and manually (by hand) shaping a free-standing wire stem having any of the springable configurations described herein. It will be seen that a compressive force (e.g., of several ounces, applied by the user's fingertip) applied at the tip of the wire stem, towards the block, will result in the wire stem deforming - there being very little "springiness" to the wire stem itself. An analogy to an overcoated wire stem formed according to the present invention would be more like a steel wire (such as a 15,24cm (six inch) length of coat hanger wire) shaped in the same manner as the solder, in which case the steel wire will exhibit noticeable springiness (or springback) when a compressive force is applied thereto. (It is understood that the steel wire is not an "overcoat" over a deformable wire stem.) The overcoat (e.g., of nickel) on an easily shaped wire stem (e.g., of gold) will exhibit resiliency analogous to that of the coat hanger wire.

In other words, whereas prior art wirebonding, involving bonding an end of a wire at a location, moving (up and over, then down) to another location, then bonding and severing could be considered as imparting a "shape" to the resulting wire, the (generally arcuate) resulting shape is relatively incidental. In contrast to this, according to the present invention, the wire is advertently (rather than incidentally) "**fashioned**", or "**configured**", essentially all along its length to have a particular functional (proto-spring) shape. Another useful terminology for describing imparting a to-be-resilient (when overcoated) shape to the wire is "**convoluting**" (or "configuring") the wire into a "convoluted" shape (or "configuration").

The general inability of a prior art wirebonding loop to function as a resilient contact structure, even if were overcoated (e.g., with nickel) can be demonstrated by inserting both ends of the aforementioned coat hanger wire into two holes in the wooden block, and applying the same compressive force thereto (at the top of the curve, rather than at the tip). Even with this "crude" model, the loss of springiness can readily be observed.

In many of the embodiments described hereinbelow, a wire is fashioned (configured) to have at least two bends, which also distinguishes the "fashioning" (configuring, shaping, forming) of a shape of the present invention from incidental, typically one bend shapes of the prior art. In another sense, the present invention contemplates advertently "**developing**" a shape which will function (once overcoated) as a spring in the wire.

In many of the embodiments described hereinbelow, the wire is configured to have a shape that commences in a particular direction (typically away from the surface of the substrate), then bends in one direction, then bends in another direction, then finishes in the same particular direction from whence it commenced (i.e., away from the surface of the substrate.

According to the invention, once the wire is bonded to the substrate, fashioned to have a shape, and severed to have be a wire stem having a distal end, the resulting wire stem is coated.

Generally, the coating applied to the wire stem is a conductive, metallic material, such as a metal, such as nickel, cobalt, copper, alloys thereof, and the like, described in greater detail hereinbelow.

The overcoated wire stem is considered to be a "**resilient**" and/or "**compliant**" contact structure which generally derives its spring-like (resilient) characteristics (e.g., compliance without plastic deformation) from the mechanical characteristic of the overcoat material and the springable shape of the wire stem. The overall springiness of the resilient contact structure is a result of these collectively "organized" (selected) features.

Prior to continuing with this discussion, it is advantageous to clarify certain terms that are used herein - namely:
- **"flexible"** refers to the ability of a thing to readily be bent or twisted, without breaking, and is especially applicable to the wire stem of the present invention.
- **"resilient"** refers to the ability of a thing to resume its original shape or position after being compressed or deflected, and is especially applicable to the overcoated contact structure of the present invention.
- **"elastic"** refers to the ability of a thing to resist deflective (compressive or tensile) forces, and to resume its original shape after the compressive forces are removed. A common spring exhibits elastic behavior. Elastic is similar in meaning to resilient.
- **"plastic"** refers to the ability of a thing to be deformed, without breaking, and is similar to flexible.
- **"compliant",** as used herein, refers to a thing exhibiting both elasticity and plasticity. In this sense, the term "compliant" is broader than the term "resilient". The contact structure of the present invention, having a flexible (plastic) wire stem and a resilient (elastic) overcoat, can be considered to be compliant.

For example, compliant contact structures formed according to the techniques of the present invention may exhibit a combination of elastic deformation (pure resiliency) and plastic deformation (pure flexibility), such as 0,0762 mm (3 mils) of elasticity and 0,1778 mm (7 mils) of plasticity for 0,254 mm (10 mils) of overall deflection. Generally, this ratio of plasticity to elasticity is readily adjusted by the material composition of the overcoat (i.e, for a given wire stem). For example, pure soft nickel will exhibit a relatively large amount of plasticity, as compared with elasticity.

The relevant mechanical characteristics of the coating material include: thickness, yield strength, and elastic modulus. Generally, the greater the thickness, the greater the yield strength, and the lower the elastic modulus of the overcoat material, the greater the resiliency of a resulting resilient contact structure will be.

Generally, the wire stem itself is intended simply to establish a "form-sustaining" shape for the overcoat material, without adversely impacting the mechanical behavior of the resulting resilient contact structure. As mentioned hereinabove, this is akin to the purpose of a "falsework", although the wire stem may remain in place after it is overcoated.

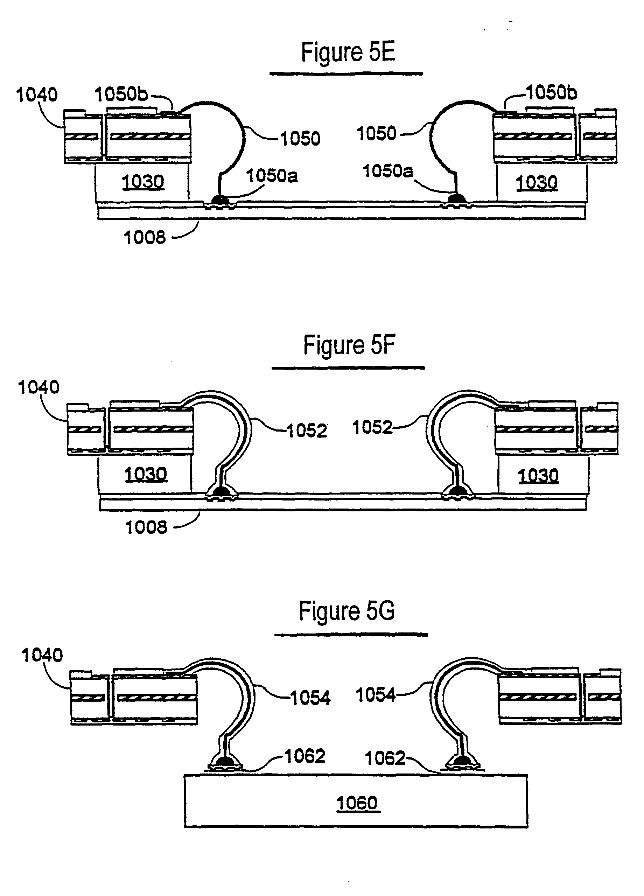

**Figure 2**, similar to Figure 5 of CASE-2, shows an exemplary wire stem 530 (compare 202, 330) comprising a wire 502 which has had its proximal end 502a (compare 202a) bonded to a terminal 512 (compare 112) on a substrate 508 (compare 108, 208), which has been fashioned to have a shape, and which has been severed to have a ball 534 (compare 434) at its distal end.

It is evident that the exemplary wire shape shown in **Figure 2** can be resilient, functioning as a spring and reacting a force (labelled "F") directed axially (i.e, generally in the z-axis direction) downward upon the wire stem. However, as mentioned above, in order for a wire stem to be resilient, it must itself have a significant content of resilient material, and gold (the "conductor of choice" for semiconductor interconnect applications) is not resilient (it is readily plasticly deformed in reaction to an applied force). As further mentioned hereinabove, the ability to form resilient contact structures would be (and is) desirable for a wide range of applications. Evidently, if the wire itself were resilient (capable of functioning as a spring), and depending on the particular shape imparted to the wire, a tremendous amount of force could easily be imparted to the bond at the proximal end (bond 502a) of the wire stem, resulting in fracture of the bond and total failure of an interconnection effected by the wire stem between electronic components. A key feature of the present invention is avoiding this problem.

According to the invention, one or more layers are coated, such as by plating, onto the wire stem 530 and, in the case of multiple layers, the outermost (top) layer is a conductive material. The principal results achieved by coating the wire stem are:
(a) imparting resiliency to a contact structure comprising the overcoated wire stem, especially in the situation where the wire stem itself is of a material (e.g., gold) that is inherently non-resilient; and
(b) improving anchoring of the wire stem to the substrate.

**Figure 2** shows a wire stem 530 having a multi-layer (two layer coating) enveloping (covering the entirety of) the wire 502 and comprising a first, inner coating layer 520 covering the wire 502 and a second, outer (top) coating layer 522 covering the first layer 520. The first layer 520 covers the terminal 512 (compare 112, **Figure 1A**) to which the proximal end 502a of the wire 502 is bonded, and anchors the wire thereto (i.e., greatly augments the bond anchoring of the wire). The second layer 522 covers the first layer 520 in the area of the terminal 512, and augments anchoring the wire 502 to the terminal.

Vis-a-vis the two layers 520 and 522 overcoating the wire stem, one (or both) imparts resiliency to the (otherwise non-resilient) wire stem, and the outer layer (or both layers) is electrically conductive.

For example:
- the wire (502) is a soft gold material, and has a diameter of 20-40 µm (0.0008 - 0.0015 inches);
- the inner coating (520) is a copper "strike", having a thickness of 130-260 nm (5-10 µ" (microinches)); and
- the outer coating (522) is nickel, and has a thickness of 50 µm (0.0020 inches).

Generally, a coating such as copper would be chosen for two reasons: (i) to enhance the plating ability of the underlying wire stem (as is known, certain materials are notoriously difficult to plate, for example with nickel), and/or (ii) to ensure good electrical current carrying characteristics for the resulting overcoated wire stem (copper is known to be a good conductor of electricity).

Generally, a coating such as nickel, or its alloys, would be chosen for its mechanical characteristics, among which are its high yield strength, to be able to elastically react applied forces, and its ability to firmly anchor the resulting resilient contact structure to the contact area (e.g., terminal).

In some instances, it would be desirable that a top (e.g., third) overcoat layer would provide solderability or the like, and would be galvanically compatible with the material of the contact area. In such instances, for example, a thin top coat hard gold, having a thickness of approximately 2.5 µm (100 µ" (100 micro-inches, 0.0001 inches) would be in order.

In high frequency applications, there would be a tendency for current to be distributed along the outer layer(s) of the coated wire stem. In such a case, gold is a good choice for the outer layer of a multi-layer overcoat.

**Figure 2A** shows a wire stem 530 having only one layer 540 (versus the multilayer overcoating 520/522 of **Figure 2**) overcoating and enveloping (fully covering) the wire stem, and encompassing the terminal 512 on the substrate 508. As in the example shown in **Figure 2**, the proximal end 502a of the wire 502 is bonded to the terminal 512, and the distal end of the wire 502 is provided with a ball 534. In this case, the coating layer 540 is both resilient and conductive.

For example:
- the wire (502) is a gold material, and has a diameter of 20-50 µm (0.0007 - 0.0020 inches);
- the coating (540) is a nickel material, and has a thickness of 12-75 µm (0.0005 - 0.0030 inches).

**Figure 2B** shows a wire stem 530 having only one layer 544 overcoating and jacketing (partially covering) the wire stem, and encompassing the terminal 512. In this case (jacketing), the overcoat layer 544 extends from the proximal end 502a of the wire stem only partially towards the distal end 534 of the wire stem. Preferably, and significantly, the overcoat 544 encompasses the bends in the wire stem, as shown. Generally, the vertical (as shown) end portions of the wire stem do not contribute to the overall resiliency of the resilient contact structure. In this case, it is important that the wire stem 530 itself be electrically conductive, since it sticks out from the coating (544) and makes the electrical contact to a contact pad (not shown) on an electronic component (not shown).

For example:
- the wire (502) is a gold material, and has a diameter of 20-50 µm (0.0007 - 0.0020 inches);
- the coating (544) is nickel, and has a thickness of 12-75 µm (0.0005 - 0.0030 inches.

**Figure 2C** shows a wire stem 530 overcoated with a single layer 548, in a manner similar to **Figure 2A** (compare 540). In this case, the layer 548 is provided with a plurality of microprotrusions on the outer surface thereof spaced longitudinally along the length of the wire stem. Such a "jagged" coating is sometimes referred to as "dendritic". These protrusions, or surface irregularities, can be created in a number of ways, for example, by adjusting the processing conditions in a plating bath (discussed hereinbelow) to cause sharp nodules to be formed in the layer 548. This is exemplary of the outer, conductive layer of a multilayer coating (compare 522, **Figure 2**) being provided with microprotrusions.

For example:
- the wire (502) is a gold material, and has a diameter of 20-50 µm (0.0007 - 0.0020 inches);
- the coating (548) is a nickel material deposited to a thickness of 12-75 µm (0.0005 - 0.0030 inches), using known techniques for co-deposition, the "foreign" (non-nickel) particles of the co-deposition suitably being silicon carbide, alumina, diamond or the like (both conductive and non-conductive materials can be used), having a diameter of approximately 3 µm (microns). Such a co-deposition will result in jagged peaks on the outer surface of the coating, the peaks having an average peak height of approximately 12 µm (0.0005 inches). Co-deposition can also be performed with particles of the same material as the ion of interest in solution (e.g., nickel particles in a nickel plating bath).

Another technique (i.e., other than the aforementioned co-deposition) for forming a "jagged" coating (e.g., 502) is, in the context of electroplating, to use "abnormally" high current and an "abnormally" low concentration of metal in the plating solution. This, as is known, will produce a "microtreeing" effect, wherein nodules are formed in the plating.

**Figure 2D** shows a wire stem 530 overcoated with a multilayer coating comprising an inner layer 552 (compare 520, **Figure 2**) which is provided with microprotrusions (as described with respect to **Figure 2C**). An outer, "normal", conformal layer 556 deposited atop the inner layer 552 may be deposited in a "normal" manner (without causing it to have microprotrusions), and will generally conform to the microprotrusion topography of the inner layer 552 to exhibit microprotrusions. (For example, a strike of gold can be applied over a nickel layer having microprotrusions.) This, evidently, is desireable in the case of (i) desiring a multilayer coating, and (ii) it being easier to form the microprotrusions in the inner layer.

**Figure 2E** shows an embodiment of the invention wherein a wire 502 is bonded at its proximal end 502a to a terminal 512 on a substrate 508, and is overcoated with an exemplary single layer conductive coating 562. In this case, the entire lower portion of the wire stem 530, including an area encompassing the terminal 512 is embedded in a mass 564. The mass 564 is preferably an electrically conductive polymer mass, such as silicon rubber filled with silver particles, and serves to reduce any parasitic inductance exhibited by the wire stem. Suitable electrical characteristic of the mass 564 are conductivity in the range of 10'2 to 10⁻⁶ ohm centimeters. The material of the mass 564 is selected so as not "creep", or to significantly adversely affect (restrict) movement (resilience, compliance) of the wire stem 530.

For example:
- the wire (502) is a gold material, and has a diameter of 20-50 µm (0.0007 - 0.0020 inches);
- the coating (562) is nickel, and has a thickness of 12-75 µm (0.0005 - 0.0030 inches); and
- the polymer mass (564) has a Shore A hardness of between 10 and 60 (such as between 30 and 50), and is filled with silver particles to impart the desired conductivity. Generally, the polymer mass is chosen so that it does not significantly impair the compliance of the contact structure. It is within the scope of this invention that intrinsically conductive polymers, which are becoming available, may be used for the polymer mass (564).

The main purpose of the elastomer mass 564 is to provide a conductive path between the distal tip and the proximal end of the wire stem (or, more accurately, the closest point on the terminal 512 to the distal tip of the wire stem) which is shorter than the overall length of the wire stem. The shortest path between two points being a straight line, it is within the scope of this invention that the polymer mass is provided only within the area indicated by the dashed lines

**Figure 2F** shows an exemplary, overcoated, freestanding, resilient contact structure 530 extending from a terminal 512 (compare 212) on a substrate. In this illustration, the distal end (tip) 530b of the contact structure 530 (without any force applied thereto, and shown as a solid line) is at a position "**A**" above the surface of the substrate. A force, indicated by the arrow "**F**", applied axially (towards the substrate 508) through the distal end of the resilient contact structure 530, will cause the resilient contact structure 530 to deflect - as shown in dashed lines -so that the tip of the contact structure (with the force applied thereto) is at a position "**B**" above the surface of the substrate. The deflecting force "**F**" will result from urging the substrate 508 which may, itself, be an electronic component, against another electronic component to effect an interconnection, via the resilient contact structure, between the two electronic components, or vice-versa.

The position "**B**" is closer to the surface of the substrate 508 than the position "**A**". Between these two positions (A and B), a position **"C"** is indicated. In use (e.g., as an interconnect between two electronic components), upon application of a force (F) the resilient contact structure 530 may first plasticly deform from the position "**A**" to the position "**C**" and, upon further application of force ("**F**"), will elastically (resiliently) deform from the position "**C**" to the position "**B**".

This "combination" of plastic deformation and resiliency is what is meant by **"compliance"** (versus **"resilience"**) and is not necessarily bad, and may be very advantageous in ensuring uniform contact force, from contact-to-contact, when the tips of a plurality of contact structures do not uniformly contact an electronic component, such as a printed circuit board (PCB), the surface of which is not perfectly planar. Those contact structures first striking the surface of the PCB will plasticly deform more than those contact structures last contacting the surface of the PCB, but the compressive force experienced by all of the contact structures will be fairly uniform.

An exemplary resilient contact structure (e.g., 530 of **Figure 2F**) will, according to the present invention, will preferably have an overall height (i.e., the distance, in the z-axis, from the surface of the substrate to the distal end of the contact structure) of 0.25 - 3 mm (0.0100 - 0.1200 inches), and will likely (i.e., for most conceivable applications) have a spring constant (**"k"**) of between 4 - 800 g / mm (0.1 and 20.0 g/mil (grams per thousandth of an inch), preferably between 20-200 g/mm (0.5 and 5.0 g/mil).

One having ordinary skill in the art will appreciate that it is difficult to set forth a "preferred" spring constant, the resiliency and/or compliancy of the contact structure being dictated by the particular application requirements. Suffice it to say that virtually any conceivable combination of elasticity and plasticity can be achieved, according to the techniques set forth hereinabove, by manipulating the thickness, shape and material of the wire stem, and the materials and thicknesses of the overcoat(s). For purposes of this discussion, however, a spring constant (**"k"**) of 120 g/mm (3.0 g/mil) is generally "preferred" for electronic applications such as using the contact structures of the present invention to connect to semiconductor dies (whether mounted directly to the dies or as a probe). Overall compliance of the contact structure is suitably up to 0.4 mm (15 mils), of plastic deformation (e.g., the distance between the positions "**A**" and "**C**") and up to 75 µm (3 mils) of elasticity (e.g., the distance between the positions "**C**" and "**B**"). The relative contributions of elasticity and plasticity are readily tailored for individual applications. For example, contact structures on an interposer may be fabricated to exhibit a total of 250 µm (10 mils) of deformation, allocated as 125 µm (5 mils) of plastic deformation and 125 µm (5 mils) of elastic deformation. Contact structures exhibiting substantially "pure" elasticity can also be fabricated.

The possibility of coating the wire stem by plating has been mentioned hereinabove. According to the invention, a number of different techniques can be used to overcoat the wire stem to establish the mechanical and chemical properties of the resulting resilient contact structure.

A notable (e.g., important) feature of the coating applied to the wire stem is that it is continuous - in other words, formed of a homogeneous material along the entire length of the wire stem. This advertent avoidance of discontinuities in the composition or metallurgy of the coating minimizes the occurrence of local stress points which would tend to lead to failures from repeated flexing of the resulting resilient contact structure.

Generally, the material of the coating is significantly stronger than the material of the wire and imparts the desired "springiness" to the resulting contact structure.

The coating can be applied using a number of readily-available techniques including, but not limited to:
(a) wet electrochemical techniques, including electrolytic or electroless aqueous solution plating of metals;
(b) electroplating, such as electroplating nickel out of nickel and its alloys, or electroplating nickel out of standard nickel sulfamate solution. This method is capable of depositing a controlled thickness coating on the wire stem having a tensile strength in excess of 5,600 kg/cm² (80,000 pounds per square inch (psi)), such as in excess of 14,000 kg/cm² (200,000 psi);
(c) chemical vapor deposition (CVD), microwave enhanced CVD (MECVD), physical vapor deposition (PVD), and the like, including any process involving evaporating and sputtering.
(d) any of a number of processes (CVD being one of such processes) that cause deposition of materials (e.g., conductive materials) through the decomposition of gaseous, liquid or solid precursors.
(e) for depositing solder on the wire stems, wave soldering or electrolytically-deposited solder.

The aforementioned wet electrochemical and electroplating processes are generally performed according to "standard" procedures, and can be performed using molten salts, ionic solutions, and the like.

For the purposes of this patent application, the process of providing a coating on the wire stem according to any of the techniques described above are, in aggregate, termed "overcoating" (the wire stem).

A useful analogy in describing the resilient contact structure of the present invention, which was set forth in CASE-1, is conceptualizing the wire stem to be a "**skeleton**", and the coating on the wire stem to be "**muscle**", since it is the wire stem that defines the shape of the resulting contact structure, and it is the coating on the wire stem that imparts the salient mechanical characteristic (e.g., resiliency) to the wire stem. As noted hereinabove, a more useful analogy may be to consider the shaped wire to be a "**falsework**" or a "**mandrel**", which functions primarily to establish the resulting shape of the overcoat.

Generally, the importance of overcoating (e.g., plating) to the process cannot be underemphasized, and should not be under-appreciated, the overcoat serving as the principal structural element in the resulting contact structure.

In the past, plating has generally been viewed as a process whereby the properties of an underlying structure can be enhanced. This would include plating to avoid corrosion of the underlying structure, to alter the appearance of an underlying structure, and to impart desireable characteristics (such as solderability) to the surface of the underlying structure. In other words, plating, per se, has generally not been viewed as an "end", in and of itself - plated structures relying on properties of the underlying structure itself to perform their intended function. Automobile bumpers, for example, would work quite well if they were not plated - the plating providing protection against corrosion as well as an aesthetic appearance to the bumper.

In conventional electronic interconnections, such as described, for example, in the aforementioned U.S. Patent No. 5,317,479, plating is used to enhance the solderability of the underlying lead structure. Without the underlying lead structure remaining intact, the concept of a compliant lead falls apart.

In contrast to the conventional plating "mind set", the present invention relies on the plating (i.e., the overcoat material) to establish the desired functionality - virtually all of it. It will be described hereinbelow how the wire stem could be removed, virtually in its entirety, after overcoating it, and the result would still be a completely functional resilient contact structure. (It is recognized, however, that processes of plating on mandrels of ceramic, wax, plastic, and the like, have been employed for phonograph record mastering, radiators for motor vehicles, etc..)

Returning to a discussion of coating (e.g., plating), in the context of fabricating resilient and/or compliant electrical contact structures, according to the present invention:

Suitable materials for the coating (i.e., for any one of the coating layers in a multi-layer coating over the wire stem) include, but are not limited to:
- nickel, copper (especially in a thin "strike", as an intermediate layer of a multilayer coating, such as over a gold wire stem, or as a current-carrying layer), cobalt, iron, and their alloys (such as nickel-cobalt), including Kovar (tm) (e.g., 29% Nickel; 17% Cobalt; 0.3% Manganese; remaining % Iron), "Alloy 42" (42% Nickel; 0.1% Carbon, remainder iron), or any similar material having Fe/Ni/Co content (e.g., 42% Nickel, 40.7% Iron, 17% Cobalt and 0.3% Manganese), or low expansion alloys;
- gold (especially hard gold) and silver, both of which exhibit excellent current-carrying capabilities;
- elements of the platinum group;
- noble or semi-noble metals;
- tungsten and molybdenum (both of which are suitably deposited by CVD processes);
- cobalt;
- zinc (especially over an aluminum wire stem);
- tin (especially for forming a eutectic, as discussed hereinbelow);
- solder (primarily for fabricating raised solder contacts);
- semi-noble metals and their alloys, selected from a group consisting of platinum, rhodium, ruthenium, other elements of the platinum group, and copper, and their alloys with gold, silver and copper (especially for top coating layers).

The technique selected for applying these coating materials over the various wire stem materials set forth hereinabove will, of course, vary from application-to-application. For example, gold is one of the preferred materials for the wire stem. However, due to its superior electrical characteristics, it is somewhat counter-intuitive to plate over gold. Moreover, gold is not a good "initiator" for plating. Hence, according to an aspect of the invention, when plating (especially electroless plating) nickel over gold, it is desirable to first apply a thin copper "strike" layer over the gold wire stem.

In a freestanding resilient contact structure, nickel is a suitable overcoating material, especially as an inner one (compare 520) of a multiple-layer coating. Such an inner layer of nickel, which has a tendency to oxidize, is suitably overcoated with a noble or semi-noble top coating layer (compare 522) such as gold, silver, elements of the platinum group and their alloys.

In use for a contact structure intended to function as a raised solder contact (as described in greater detail hereinbelow), nickel, cobalt and their alloys are suitable overcoat materials and, for example, can suitably have a thickness in the range of from 0.8 - 125 µm (0.00003 to 0.00500 inches), preferably from 1-75 µm (0.00005 to 0.00300 inches).

Solder, which typically includes lead and tin elements, is also suitable for an overcoat, and can be applied to the wire stem by conventional wave soldering equipment. Embodiments of the invention utilizing a solder overcoat are described in greater detail hereinbelow.

A significant advantage of forming a multiple layer coating over the wire stem is that the materials of each individual coating layer can be selected to tailor the set of physical properties of the resulting resilient contact to a given application. These physical properties include tensile strength, yield strength, and the like.

Another advantage of forming a multilayer coating over the wire stem is exemplified by the fact that nickel has a strong tendency to oxidize, and consequently typically requires large contact forces to break through the formed oxides. (Low contact forces resulting in good electrical connections are generally universally preferred.) For this reason, nickel tends not to be the best choice for a single layer coating, or for the top layer of a multilayer coating on the wire stem.

Similarly, although a solder top coat would be highly desirable for certain applications, typical solders include tin, and gold (i.e., a gold wire stem) is very reactive with tin. To inhibit such undesired reactions, an intermediate "barrier" layer can be applied between the wire stem and a top layer of the coating. In the case of a gold wire stem and a solder (having tin) top layer, a barrier layer of nickel alloy will deter the reaction between the gold (wire) and the tin (solder overcoat), in most instances. For example, a first coating layer of nickel alloy, having a thickness of 2.5-25 µm (100 to 1,000 microinches), can be applied between a gold wire and a top coating layer of solder.

Inasmuch as the resilient contact structure is intended to function as a "spring", certain advantages will accrue (in certain applications) when internal compressive stresses are induced in a coating (at least one layer of the coating) during applying the coating to the wire stem. For example, to induce internal stress in the coating, as it is being plated onto the wire stem, certain additives can be added to the plating solution. For example, in a nickel sulfamate plating solution, the following additives (additive agents) can be added to the plating solution: saccharin (sodium salt), thiourea, butyne diol, meta-benzene disulphonic acid (sodium salt), 1,3,6 napthalene trisulphonic acid (trisodium salt), and the like. Boric acid can also be added to the plating solution (bath), for pH control. Internal stress in the plating can also be controlled by the overall temperature of the plating bath, plating rate, pH of the plating solution, nickel (e.g.) concentration, and other plating parameters. Generally, the additives agents mentioned hereinabove are the primary contributors to controlling stresses in the plating, including compressive stresses, tensile stresses and "theta" (θ) stresses.

If the wire stem itself has some inherent resilience which is sought to be "adjusted", vis-a-vis the resilience of the coating, a shaped wire stem (or a plurality of shaped wire stems) can be placed under stress (pre-compressed by a force "F", as shown in **Figure 2F**) while overcoating (e.g., plating) the stem. Such a "mechanical" means of pre-stressing the contact structure may also be desirable in certain applications.

According to the present invention, an overcoated wire stem functions as a spring, the spring constant ("**k**") of which can readily be calculated for any given configuration, based on known properties of materials. Generally, as described hereinabove, the overcoat is applied to a more-or-less uniform thickness along the length of the wire stem - at least, along the bend portions of the wire stem - simplifying such calculations. Using processes such as electroplating tend to result in substantially uniform thickness along the length of the wire.

According to an aspect of the present invention, the coating is applied so as to have an advertent, non-uniform thickness along the length of the wire stem.

**Figure 2G** illustrates a wire stem 530 that has been plated with an overcoat 568 while applying "localized" heat (arrows marked "H") to the substrate. This is readily accomplished by disposing the substrate 508 atop a heat strip (not shown). In this manner, the substrate and the wire stem will be hotter than the surrounding plating bath.

Despite the fact that a gold wire (502) is a reasonably good thermal conductor, the fact that the entire wire stem 530 is immersed in a plating bath during the plating operation will result in there being a noticeable temperature gradient along the length of the wire stem, with the proximal end 502a of the wire stem being hotter than the distal end 502b of the wire stem. This will result in the coating having a greater thickness at the proximal end of the wire stem than at the distal end of the wire stem. (This variation in thickness is exaggerated in the illustration of **Figure 2G**, for illustrative clarity. Compare **Figure 2B.**)

By advertently causing the coating (568) to be thicker where the wire stem is anchored to the substrate, than at the free-standing end of the wire stem, the following advantages accrue:
- the anchoring of the wire stem to the substrate will be greater, for a given "average" coating thickness;
- the compliance of the resulting resilient contact structure will be greater - there being a lesser thickness of coating material for a given average coating thickness - at the distal, resiliently-operative portion of the wire stem; and
- consequently, stresses imposed by a resilient force will better be reacted at the proximal end (502a) of the wire stem -thereby reducing any tendency of the resilient contact structure to fracture from the substrate.

By way of example, elevating the temperature of the substrate to 80°C - 10°C (the overall temperature of the plating bath being at room temperature), coatings which otherwise would deposit themselves uniformly along the length of the wire stem can be induced to demonstrate a thickness gradient of from 1.5:1 to 5:1 (thick:thin). This aspect of the invention is applicable both to electroplating and to electroless plating.

Conversely, cooling the substrate (relative to the bath), for example with a thermocouple device, can be employed to tailor the coating thickness.

It is within the scope of this invention that any suitable technique can be employed to tailor the thickness of a member being plated by imposing a temperature gradient upon the member being plated.

According to the present invention, localized heat (i.e., versus overall heating of the plating bath), applied during a plating process, can advantageously be employed to "tailor" coating thickness in a number of contexts. It can be employed, as described hereinabove, to advertently make the coating thicker, the closer it is to the heat source. It can be used to make an otherwise uniform thickness coating non-uniform. For example, if, without applying heat, the coating (e.g., nickel) tended to be thicker at the distal end of the wire stem, the coating thickness can be "beefed" up to make the coating exhibit a uniform thickness along the length of the wire stem or, as described hereinabove, to make the coating thicker at the proximal end of the wire stem. Additionally, in certain applications wherein it is desired to deposit a uniform thickness coating across the surface of a planar substrate, heat can be employed to "counteract" certain inherent tendencies for the plating to be non-uniform (i.e., thinner in spots), thereby ensuring a uniform coating thickness across the surface of the substrate (e.g., a silicon wafer). (Spots or areas on the surface of the substrate tending to have a thin coating can be locally heated to thicken the coating in these areas.) This. too, is within the scope of the present invention.

**Figure 2H** illustrates an example of tailoring coating thickness similar to that shown with respect to **Figure 2G**, but in the context of coating a straight wire stem (e.g., "pin") 570. A straight wire stem 502 is bonded by its proximal end 502a to a terminal on a substrate. Heat ("H") is applied to the substrate during plating. The resulting overcoat 578 will be thinner towards the distal tip 502b of the wire stem 502 than at the proximal end 502a of the wire stem.

In many of the embodiments described herein, nickel is very suitable for the overcoat material (e.g., of at least one of the overcoat layers), and is deposited onto the wire stem by plating. Although such processes are generally well understood, and well within the purview of one having ordinary skill in the art to which the present invention most nearly pertains, a comprehensive discussion of nickel plating can be found in Nickel Plating by Roger Brugger, Robert Draper Ltd. (UK), 1970, the relevant teachings of which are incorporated by reference herein.

The present invention has been described in the context of bonding the free end of the wire to a contact area (see, e.g., 100, **Figures 1**) which may be a terminal (see, e.g., 112, **Figure 1A**) on a substrate (e.g., an electronic component). It is generally required that the contact area (110) be metallic and be formed of materials including, but not limited to:
(a) gold, and its alloys;
(b) aluminum, and its alloys;
(c) silver, and its alloys;
(d) copper, and its alloys; and
(e) metals of the platinum group.

In many of the examples presented herein, the contact area is a terminal (112). However, it will be understood that the contact area is not limited to a terminal, or to a bond pad, and there may be a plurality of contact areas on a single, continuous layer which is subsequently patterned, such as by photoresist and etching (see, e.g., **Figure 1B**), to have a plurality of contact areas.

The contact area (such as a terminal) may include multiple layers, the topmost layer of which is a material such as gold or aluminum. Generally, the materials of the contact area of the substrate are within a suite of known materials for such contact areas.

A number of materials have been described hereinabove as being suitable for the wire, for the coating(s) and for the defined area to which the wire is bonded. Although not forming part of this invention, a brief description of the salient characteristics of a number of these materials follows, with comments as to their utility (in some cases, nonobvious or non-intuitive) in the present invention. These brief descriptions are intended to be elaborative, and are not intended to be construed as limiting in any way. A more comprehensive "shopping list" of metal materials and their relevant properties can be found in chapter 5 ("Metals") of Electronic Materials and Processes Handbook, Harper and Sampson, McGraw-Hill, Inc., Second Edition, 1994, pages 5.1 - 5.69.

Aluminum - Because of its good electrical and mechanical properties, aluminum is an important contact material. However, as a contact metal, aluminum is generally poor because it oxidizes readily. In cases where aluminum is used in contacting joints, it should be plated or clad with copper, silver or tin.

Beryllium - This material exhibits high stiffness and strength to density ratios, high thermal conductivity, and low thermal expansion.

Copper - Copper is widely used in electrical contacts because of its high electrical and thermal conductivity, low cost, and ease of fabrication. The main disadvantages of copper contacts are low resistance to oxidation and corrosion. Pure copper is relatively soft, anneals at low temperatures, and lacks the spring properties sometimes desired.

Epoxy - Epoxy is a resin which is generally nonconductive, and which will cure (harden) at room temperature or at elevated temperatures. When used for electrical connections (e.g., in lieu of solder), a conductive epoxy filled with silver or gold particles is employed. These conductive epoxies will typically exhibit volume resistivities of less than 1 mΩ/cm (milliohms per centimeter). There are a plethora of epoxies to choose from, the ultimate choice being dictated by the application in which the epoxy will be employed.

Eutectic - A "eutectic" is a combination of metals, such as gold and tin, which exhibits a lower melting temperature than either of the constituent metals. Examples include 80% gold -20% tin (percent, by weight), and 63% tin - 37% lead. A characteristic of eutectics to expand when melted is exploited in certain of the embodiments described hereinbelow.

Gold - Pure gold has unsurpassed resistance to oxidation and sulfidation, but a low melting point and susceptibility to erosion limit its use in electrical contacts to low current applications. Gold, in contact with palladium or with rhodium, has a very low contact resistance.

Nickel - Nickel and its alloys are typically characterized by good strength and corrosion resistance. Nickel metal has relatively good electrical conductivity.

Platinum Group Metals - Platinum and palladium are the two most important metals of the platinum group. These metals have a high resistance to tarnishing, and therefore provide reliable contact closure for relays and other devices having low contact forces.

Precious Metals: The following materials generally all exhibit good corrosion-resistance (except for silver in sulfide environments): Gold, Iridium, Osmium, Palladium, Platinum, Rhodium, Ruthenium and Silver.

Silver - Silver, in pure or alloyed form, is a widely used material for make-and-break contacts. The mechanical properties and hardness of puree silver are improved by alloying, but its thermal and electrical conductivity are adversely affected.

Solder - Solders are a widely used group of alloys in the electronic and electrical industries. Their compositions are based primarily on tin and lead, with minor alloying elements such as silver and antimony. Solders are low strength materials at room temperature, and decrease rather rapidly in strength, even at the moderately elevated temperatures experienced by electronic equipment. The relative ratio of tin:lead in solder can range widely, and is nominally 50:50.

Tungsten and Molybdenum - Most tungsten and molybdenum contacts are made in the form of composites, with silver or copper as the principal other component.

The invention has been described in the context of bonding a free end of a wire to a "substrate", configuring a compliant wire stem to have a springable shape, and overcoating the wire with a spring material to form a resilient contact structure for making interconnections between two (or more) electronic components (one of which is the "substrate" on which the resilient contacts are formed). Suitable substrates include, but are not limited to the following, many of which are described in greater detail hereinbelow:
(a) interconnect and interposer substrates;
(b) semiconductor wafers and dies, made of any suitable semiconducting material such as silicon (Si) or gallium-arsenide (GaAs);
(c) production interconnect sockets;
(d) test sockets;
(e) sacrificial members, elements and substrates, as described herein;
(f) semiconductor packages ("packages"), including ceramic and plastic packages, and chip carriers, as described herein; and
(g) a connector.

According to an aspect of the invention, resilient contact structures can be formed on, or from an electronic component to, a sacrificial element.

The use of a sacrificial element in conjunction with forming a resilient contact structure is discussed in CASE-1, at Figures 6a-6c therein, which are similar to **Figures 3A-3C** herein.

**Figure 3A** illustrates at a wire 802 having its proximal end 802a bonded to a first terminal 812 on a substrate 808 can be formed into a U-shaped loop and, rather than severing the distal end 802b of the wire 802, bonding the distal end 802b of the wire to a second terminal 820 with a suitable wedge-bond or the like.

The resulting loop-shaped wire stem 830 is overcoated, as shown in **Figure 3B**, with a one or multi-layer coating 840 which envelops the entire wire stem 830 and the terminals 812, 820. The second terminal 820 is suitably positioned atop a sacrificial layer which serves as an electrical contact point for electroplating processes (if such processes are employed to overcoat the wire stem), and also serves to provide a different (higher) z-axis coordinate for the two ends of the wire stem 802a and 802b.

As illustrated in **Figure 3C**, after overcoating the wire stem, the sacrificial layer 822 can be removed (such as by selective etching), leaving a gap 824 between the end 802b and the surface of the substrate 808. The "suspension" of the end 802b is especially important for formation of controlled geometry spring contacts, capable of resiliently engaging with mating terminals on a component or a substrate for burning-in or testing (discussed in greater detail hereinbelow) an electronic component (such as a semiconductor die), or for providing a demountable electrical interconnect to an electronic component. The gap 824 allows for z-axis deflection (movement) of the tip 802b of the resulting contact structure when a force is applied thereto.

As illustrated in **Figure 3C,** it is intended that the contact structure 830 make contact at a point along its length, rather than at its distal end (802b). This is illustrated by the downward pointing arrow labelled "C".

**Figure 3D** illustrates that the procedure described immediately hereinabove could be re-ordered, so that the sacrificial member (822 of **Figure 3A**) could be removed prior to overcoating the wire stem (see, e.g., **Figure 3B**).

As used herein, a "sacrificial element", such as the element 822 described hereinabove, is generally an element (such as a layer) on the electronic component (808) to which the resilient contact structure is mounted.

The use of a sacrificial member in conjunction with forming a resilient contact structure useful as a probe is discussed in CASE-2, at Figures 14-15 therein, which are similar to **Figures 4A-4B** herein.

**Figure 4A** illustrates an embodiment 900 of the use of a sacrificial member 902 (shown in dashed lines) in conjunction with forming a resilient contact structure 930 suitable for use as a probe. In this example, the sacrificial member is suitably formed of aluminum.

A plurality (one of many shown) of depressions 904 are formed, such as by etching, engraving, stamping, or the like, in the top surface 902a of the sacrificial member 902. The bottom (as viewed) surface of the depression 904 has an irregular topography, such as in the form of inverted pyramids ending in apexes. A thin layer 906 of a conductive material, such as gold or rhodium (alternatively, tin or solder, such as when contacting solder terminals) is deposited in the depression, in any known manner. The depression 904 is then substantially filled with a conductive material 908 such as nickel, in any known manner. A layer 910 of a conductive material such as gold is then deposited over the filler material 908, in any known manner. This sandwich structure of gold (906), nickel (908) and gold (910) forms a suitable tip structure ("contact pad") for a probe.

A wire 912 is bonded at its proximal end 912a to the surface of the layer 910, and is configured to extend over an edge of an electronic component 920, whereat the wire is severed and its distal end 912b bonded to a terminal 922 on the electronic component 920. The configured shape of the wire projects off the edge of the component 920.

The wire is then overcoated with a conductive material 914, such as nickel, or with a multilayer coating as discussed with respect to **Figure 2**, which also overcoats the terminal 922 on the electronic component, in the manner described hereinabove. To ensure that the overcoating covers only a desired area on the sacrificial member, the entire surface of the sacrificial member, except for the depressions (904) can be masked with a suitable masking material, such as with photoresist (not shown). (This masking may be "leftover" from forming and filling the depressions to fabricate the contact pads.)

As is shown, the sacrificial member 902 is maintained in a predetermined position with respect to the electronic component 920 by a suitable standoff element 916 (shown in dashed lines), which may simply be photoresist material.

Upon completion, the standoff element 916 and the sacrificial member 902 are removed, leaving resilient contact structures 930 extending from the electronic component 920, each of which has a contact pad of controlled geometry at its end.

For example, the apexes of the inverted pyramids of the contact pad are useful, in the context of probing, for effecting reliable electrical connection to a terminal (pad) of another electronic component (not shown) which is desired to be probed (e.g., for burn-in, testing or the like). With relatively low overall forces involved, the points (apexes) will partially penetrate the terminal of the electronic component being probed. Generally, in this case, the electronic component 920 would be a test card (printed circuit board) having a plurality of probe structures (930) extending to an area whereat an electronic component being probed would be introduced. The test card would suitably be in the form of a ring, with the probes 930 extending from an inner edge of the ring to below the ring.

It is within the scope of this invention that the sequence of events described hereinabove be re-arranged so that:
(a) the wire 912 is bonded first to the terminal 922 of the electronic component 920; and/or
(b) the wire 912 is overcoated (914) after the sacrificial member 902 is removed.

**Figure 4B** shows an embodiment 940 of a completed probe 942 which is similar to the probe 930 of the previous embodiment 900, with the following differences. In this case, the end of the probe 942 (compare 930) is wedge-bonded to a contact pad 944 which has a single projecting nub 946, rather than a plurality of points, and the end 948 (compare 912b) of the probe 942 is ball-bonded to the electronic component 950 (compare 920).

As illustrated in **Figure 4C**, a useful (e.g., preferred) contact tip for a probe can be formed in (or on) a sacrificial member, in the following manner, on a thin aluminum (foil) sacrificial member 960:
- provide a temporary backing 962, such as a plastic sheet, for the foil, to increase the structural integrity of the foil;
- pattern the face of the foil with a thin (approximately) 75 µm (3 mil) layer of photoresist 964, or the like, leaving openings at locations whereat it is desired to form contact tips;
- deposit (such as by plating) a thin (approximately) 2.5 µm (100 µ") layer 966 of hard gold onto the foil, within the openings in the photoresist;
- deposit (such as by plating) a very thin (approximately) 120-250 nm (5.10 µ"). layer ("strike") of copper 968 onto the layer of hard gold (it should be understood that such a copper strike is somewhat optional, and is provided principally to assist in subsequent plating of the previous gold layer 966);
- deposit (such as by plating) a thick (approximately) 50 µm (2 mil) layer 970 of nickel onto the copper strike; and
- deposit (such as by plating) a thin (approximately) 2.5 µm (100 µ") layer 972 of soft gold onto the nickel.

This forms a 4-layer contact tip, to which a gold wire (not shown) is readily bonded (to the soft gold layer), having a hard gold surface (966) for contacting electronic components, a nickel layer (970) providing strength, and a soft gold layer (972) which is readily bonded to. As described hereinabove, after bonding the wire to the sacrificial member (960), the wire is plated (e.g., with nickel) and the sacrificial member is removed (or vice-versa).

The ability to form a resilient contact structure using a sacrificial element on the substrate (as in **Figure 3A**) or using a sacrificial member off of the substrate (as in **Figure 4A**) has been generally discussed, hereinabove.

As discussed hereinabove, the resilient contact structure described in **Figures 4A and 4B** are suitably employed as probes, contacting an electronic component for burning-in, and testing and exercising the functionality of the probed component.

According to the invention, resilient contact structures can be incorporated into a chip probing card.

**Figures 5A-5I** illustrate fabrication method for making a chip probing card, using a sacrificial member. Generally, openings are formed in photoresist on the sacrificial member (e.g., aluminum or copper), an optional topography is created in the sacrificial member within the resist openings (typically by an additional etching step or by a shaped tool), then at least one conductive layer is plated or deposited inside the openings, at which point the sacrificial member is mounted to (e.g., underneath) a chip probing card (this mounting could be the first step which is performed). Then, wires are bonded to the sacrificial member and to the card, and are overcoated with spring material (or any other material). Finally, the sacrificial layer is removed, without adversely impacting the contacts (probes).

It is of note, in the probe embodiments described herein having a contact pad formed at the tip of the wire, said contact pad typically having a topography favorable to making temporary connections to devices being tested (probed), that the material coating the shaped wire need not be conductive, so long as it provides the sought-after resiliency - for many applications, the wire itself providing the necessary conductive path between the probe card (e.g.) and the device being probed.

A first "phase" (Phase-1) of the process flow, involving processing a sacrificial member, is illustrated in **Figures 5A-5C**, wherein:
**Figure 5A** illustrates a first step wherein a patterned layer of photoresist 1002, having openings 1004 (one of many shown) defined therein, is applied over a sacrificial material substrate 1008, such as an aluminum or copper sheet.
**Figure 5B** illustrates a next step wherein the otherwise generally smooth, planar substrate material within the openings 1004 is "embossed" to exhibit a topography, such as by micromachining or by lithography (e.g., including etching). This is illustrated by an embossing tool 1010 pressing down upon the surface of the substrate, within the opening 1004, to create a plurality of depressions 1012 extending into the surface of the substrate 2008.
**Figure 5C** illustrates that, after the tool (1010) is removed (or the surface of the substrate is otherwise embossed, such as by etching), the surface of the substrate within the opening (1004) is plated with a thin layer 1020 of a material suitable for making contact with another electronic component, such as rhodium. Another, thicker layer 1022 of a material such as nickel is applied over the thin layer 1020. This layer 1022 substantially fills the depressions 1012 formed by embossing, and preferably overfills the depressions 1012, as illustrated. Next, a thin layer 1024 of bondable (e.g., soft) gold is applied, over the thick layer 1022, within the opening 1004. The layered structure 1026 (see **Figure 5D**) in the opening 1014 defines a contact pad to which a wire will be bonded.

Having performed the steps illustrated in **Figures 5A-5C,** the sacrificial member 1008 is ready for contact mounting.

A second "phase" (Phase-2) of the process flow, involving mounting a contact-carrying substrate to the sacrificial member (1008) and fabricating resilient probe contact structures is illustrated in **Figures 5D-5C**, wherein:

**Figure 5D** illustrates that a sacrificial member 1008, prepared per the steps of Phase-1, has a standoff element 1030 mounted to its surface, in a peripheral region thereof. The standoff element 1030 is suitably formed as a thick layer of photoresist (alternatively of a polymer, alternatively a metal shim), patterned to have a ring (e.g., square ring) profile with a central area 1032 corresponding to an area wherein, upon completion of the process, a semiconductor die (e.g.) will be introduced for contacting by probes (discussed below). A ring-shaped substrate 1040 having a central open area corresponding to and aligned with the open area 1032 is disposed atop the standoff element 1030. (The substrate 1040 is, for example, a multi-layer PCB.) A top (as viewed) surface of the ring-shaped substrate 1040 has a plurality of contact areas 1042 (compare 110, **Figure 1**) defined preferably near the opening in the substrate 1040. The substrate 1040 is illustrated as being a multi-layer circuit board (e.g., PCB) having alternating layers of insulating material and conductive material, and may have discrete electronic components mounted thereto (such as test circuitry, and the like).

It is within the scope of this invention that the substrate 1040 could simply be an insert mounted to a distinct and separate probe card (not shown).

**Figure 5E** illustrates that a wire 1050 is bonded at both its ends 1050a and 1050b (in a manner akin to that of the aforementioned loop 802) between the contact areas 1042 on the PCB 1040 and the material (1022) in the openings on the sacrificial substrate 1008 to make an electrical connection therebetween. For example, a one end 1050a of the wire 1050 is ball bonded to the layer 1022 in the area 1012, and an other end 1050b is wedge bonded to the contact area 1042. The wire 2050 is fashioned (as described hereinabove) into a shape that is suitable (once overcoated, as described hereinbelow) for functioning as a resilient probe contact structure. It is, essentially, immaterial which end of the wire 1050 is bonded first, and which end of the wire is bonded second.

**Figure 5F** illustrates that, after the wire 1050 is bonded between the substrates 1008 and 1040 (and fashioned into a shape after the first bond and prior to the second bond), the wire 1050 is overcoated with a conductive material 1052 which completely covers the wire 1050, and which also covers the contact area on the substrate 1040, and which also completely covers the area within the opening 1012 in the sacrificial substrate 1008. The method and manner of overcoating the wire with a material that will impart resilient properties to the resulting contact (prove) structure is any of the techniques described hereinabove.

**Figure 5G** illustrates that, after the wire 1050 is overcoated, the sacrificial substrate 1008 can be removed, such as by chemical etching. As illustrated, removing the sacrificial substrate will include removing the layer 1002, as well as removing the standoff element 1030. This will result in the card substrate 1040 having a plurality (two of many shown) of probe contact structures 1054 (each comprising a wire 1050 which is overcoated 1052) extending from a plurality (two of many shown) contact areas 1042 to within and below the opening in the card substrate 1040, for making resilient contact to a corresponding plurality (two of many shown) of contact areas 1062 on a semiconductor device 1060. These contact areas 1062 are typically bond pads arranged just inside the perimeter of the die 1060.

As is clearly shown in **Figure 5G**, each resilient contact probe 1054 has a tip 1054b which is formed by the layers 1022 and 1020, which is the "mirror image" of the embossed pattern provided by the areas 1012.

In this manner, resilient, temporary connections can be made between a test card (1040) and a device under test (DUT) 1060 which, as described in greater detail hereinbelow, is important for performing burn-in and testing of semiconductor devices prior to packaging the devices, or in order to produce fully-validated devices.

**Figures 5H and 5I** illustrate alternate final and penultimate steps in Phase-2, wherein the sacrificial substrate 1008 (and standoff element 1030) are removed (Figure **5H**) prior to overcoating (**Figure 5I**) the shaped wire 1050.

**Figures 5J** and **5K** illustrate alternate embodiments of resilient contact structures, functioning as probes, according to the present invention. **Figure 5J** shows an embodiment of a probe which is similar to Figure 11 of CASE-2, and **Figure 5K** shows an embodiment which is similar to Figure 12 of CASE-2.

**Figure 5J** illustrates another embodiment 1070 of a probe-like contact structure. As in previous embodiments, a wire stem 1072 (flexible elongate element) has one end 1072a bonded to a contact area 1074 on a substrate 1076. Another end 1072b of the wire stem is bonded (shown as wedge-bonded) to a pre-formed contact tip 1078 on a sacrificial member 1080, in any suitable manner, and is overcoated (e.g., with nickel material 1079) to provide the desired deflection characteristics for the resulting probe. A suitable standoff element 1083 (compare 1030) is suitably employed. Ulltimately, both the standoff element 1083 and the sacrificial substrate 1080 are removed.

**Figure 5K** illustrates another embodiment 1084 of a probe-like contact structure. As in previous embodiments, a wire stem 1086 (flexible elongate element) has one end 1086a bonded to a contact area 1074 on a substrate 1076. Another end 1086b of the wire stem is bonded (shown as wedge-bonded) to a pre-formed topological contact pad 1088 on a sacrificial member 1090, in any suitable manner. The wire stem 1086 is provided with a multi-layer coating, in the following manner. A layer 1092 of a conductive material (such as nickel) is deposited (e.g., plated) over the wire stem 1086, to impart resiliency to the wire stem and to anchor the wire stem to the contact pad 1092. A layer 1094 of dielectric material (such as silicon dioxide) is applied over the nickel layer 1092. The dielectric material (1094) may encompass (not shown) the contact pad 1088 to assist in anchoring the wire stem thereto. Next, the wire stem is masked, such as by dipping the tip of the wire stem, with contact pad attached, into a suitable masking material, such as photoresist (not shown). Finally, another layer 1096 of conductive material (such as gold) is deposited over the wire stem. This forms a coaxial (shielded) conductor, the outer layer (1096) of which can be grounded (as indicated by the ground symbol "**G**"), in any suitable manner, to control the impedance of the probe structure. A suitable standoff element 1093 (compare 1030) is suitably employed. It is within the scope of this invention that the wire stem can be overcoated (as described hereinabove) prior to attaching (e.g. by brazing) the contact pad (1088) thereto. In this example, the contact pad 1088 is shown as being "topological" (compare 1026 of **Figure 5D**), a feature which is especially useful for probing, especially for probing solder bumps (see, e.g., **Figure 7E**).

### CONTACT-FABRICATION ON A SACRIFICIAL SUBSTRATE

In the main, hereinabove, techniques have been described for fabricating resilient contact structures by bonding an end of wire to an electronic component, configuring the wire to be a wire stem having a springable shape, overcoating the wire with a resilient material, and optionally bonding another end of the wire to a sacrificial element or to a sacrificial member. In this manner, a resilient contact structure is mounted to an electronic component.

According to the invention, a plurality of resilient contact structures are fabricated, as separate and distinct structures, without mounting the resilient contact structures to an electronic component, for subsequent (after the resilient contact structures are fabricated) mounting (such as by brazing) to an electronic component. In other words, a supply (e.g., "bucket") of contact structures can be fabricated and warehoused, for later attachment (mounting) to electronic components. This is akin to the prior art technique of fabricating a plurality of pins, then later brazing them to package bodies.

**Figures 6A** illustrates a first step in fabricating discrete resilient contact structures, wherein a patterned layer of photoresist 1102 is applied to a surface (top, as viewed) of a sacrificial substrate 1104. The photoresist 1102 is provided with a plurality (three of many shown) of openings 1106a, 1106b and 1106c (e.g., using conventional screening techniques).

**Figure 6B** illustrates a next step, wherein a topography is (optionally) created in the sacrificial substrate 1104 within the resist openings by using a shaped (embossing) tool 1110. (The use of a tool is an alternate to etching a topography in the surface of the sacrificial substrate.) As illustrated in this figure, a topography has been created in the sacrificial substrate 1104 within the opening 1106a, is being created in the sacrificial substrate 1104 within the opening 1106b, and is yet to be created in the sacrificial substrate 1104 within the opening 1106c.

**Figures 6C-6E** illustrate subsequent steps in the process of fabricating a plurality of discrete resilient contact structures, for an exemplary one of the plurality of contact structures (within an exemplary corresponding one of the openings 1106a).

**Figure 6C** illustrates the formation of a contact tip 1120 (compare 990) within the opening 1106a, by plating a first conductive layer (e.g., of hard gold) 1122 on the sacrificial substrate 1104 within the opening 1106a, plating a second conductive layer (e.g., of nickel) 1124 atop the first layer 1122, and plating a third conductive layer 1126 (e.g., of hard gold) atop the second layer 1124. (The three-layer contact tip shown in this set of figures is merely exemplary, it being understood that at least one layer is required.) Generally, the bottom layer 1122 should be of a material which is amenable to making contact with electronic components, and the top layer 1124 should be of a material that is amenable for bonding to a wire stem. As describe hereinabove, a four-layer structure can be formed, comprising a thin layer of hard gold (for contacting electronic components), followed by a very thin layer of copper, followed by a layer of nickel, followed by a thin layer of soft gold (for bonding a gold wire stem). It should be understood that the thin copper layer is optional.

**Figure 6D** illustrates the bonding of a wire to the contact tip 1120, and shaping of the wire to be a wire stem 1130 in any suitable manner set forth hereinabove.

**Figure 6E** illustrates overcoating the wire stem with a springy (e.g., nickel) material 1132, in any suitable manner set forth hereinabove. (Compare, e.g., **Figure 2A**).

**Figure 6F** illustrates a final step, wherein the sacrificial substrate 1104 and photoresist 1102 are removed, by any suitable process, such as washing off the photoresist, and dissolving the sacrificial substrate. This completes the fabrication of a resilient contact structure 1130 having a contact tip 1120.

In this manner, a plurality of individual resilient contact structures can be formed. Contact structures formed, for example, by the technique illustrated in **Figures 6A-6F** can be mounted (such as by brazing, soldering, epoxy attachment, or the like) to pads on an external surface of a semiconductor package, individually, on a one-by-one basis. As described immediately hereinbelow, it is preferable, in a number of applications, that a plurality of contact structures be transferred at once ("gang" transferred) to the external surface of a semiconductor package.

### CONTACT GANG TRANSFER

As described hereinabove, with respect to **Figures 6A-6F**, a plurality of discrete "not-mounted" resilient contact structures can be formed for subsequent mounting to an electronic component.

According to the invention, a plurality of resilient contact structures can be fabricated on a sacrificial substrate (e.g., in the manner of **Figures 6A-6E**), then mounted en masse (gang transferred) to an electronic component. (Generally, this is achieved by omitting the step of de-mounting the contact structures from the sacrificial substrate - or, omitting the step illustrated in **Figure 6F**).

According to the invention, a plurality of previously-formed, resilient contact structures, mounted to a sacrificial carrier (sacrificial substrate), can be transferred in a single step (gang transferred) to an electronic component, such as a fully-assembled ceramic package.

**Figure 7A** shows a fully-assembled ceramic package 1250 comprising a package body 1252 (compare 702) having a central cavity 1254 (compare 704) in which a semiconductor device (die) 1256 (compare 706) is mounted. As illustrated, the die 1256 has a plurality (two of many shown) of bond pads disposed about a peripheral region of its front surface, and the package body has a corresponding plurality (two of many shown) of terminals (inner ends of conductive traces) disposed about the periphery of the cavity. The bond pads of the die 1256 are connected, on a one-to-one basis, to the terminals of the package body, in a conventional manner, with bond wires 1260 (compare 710), and the cavity 1254 is sealed with a lid 1258 (compare 708). This is exemplary of prior art "cavity-up" packaging techniques, wherein the entire bottom surface of the package body can be "fully-populated" with an array of conductive pads 1280, to which pins, ball bumps, or the like are mounted for effecting connections between the semiconductor package and external devices or systems. In the case of "cavity-down" packaging, the lid would occupy a central region of the package exterior, and the pads (1280), would "partially-populate" the surface of the package body, outside of the central region of the lid. The present invention is applicable to either cavity-up or cavity-down packaging techniques, and to either fully- or partially- populated arrays.

Generally, in the prior art, contact structures such as pins are individually transferred to an electronic component such as a ceramic package using automated equipment. Generally, special molds or fixtures are required which typically can be used only for a given, individual package (and pin) configuration. This represents a tooling step which throws a time lag into the product development cycle, and a tooling cost which is difficult to amortize for short-run devices. Moreover, control over the process is imperfect, resulting in one or more pins requiring removal and replacement, typically by hand. This is not cost effective, as illustrated by an example of a package containing an expensive chip (e.g., a $1000 semiconductor device). Re-working the package to replace defective pins can result in damaging the chip.

**Figure 7A** shows a plurality of resilient contact structures 1230 (compare 1130) which have been fabricated on a sacrificial substrate (compare 1104). This corresponds to the previously-described **Figure 6E**, with the photoresist (1102) washed off the sacrificial substrate (1104), although washing off the photoresist at this step in the process is not absolutely necessary. As illustrated in this figure, a plurality of contact structures 1230 mounted to a carrier 1204 are brought into a position to be mounted to the package 1252, with the tips 1230b of the contact structures aligned with the pads 1280 on the package. This is readily accomplished with automated parts handling equipment. As further illustrated in this figure, a quantity of solder 1282 (alternatively, braze material, conductive epoxy, or the like) is disposed on each of the contact pads 1280, prior to introducing the contact structures 1230.

In **Figure 7B**, it is illustrated that the contacts have been brought to bear, en masse, upon the corresponding contact pads 1280, with their tips immersed in the solder 1282. This is accomplished (in the case of using solder) by performing this step in a furnace (to reflow the solder). As illustrated in this figure, it is not essential that the tips 1203b of the contact structures physically contact the contact pads 1280, since the solder will reflow around the tip portion of the contact structure 1203 and effect a reliable electrical connection between the contact structure and the contact pad.

**Figure 7C** illustrates a final step, wherein the sacrificial substrate 1204 is removed (compare **Figure 6F**).

In the aforementioned manner, a plurality of resilient contact structures can be pre-formed, and subsequently (later) mounted to a surface of an electronic component (e.g., a package body). It is within the scope of this invention that pre-forming the contact structures can be accomplished by molding techniques using, for example, ceramic or graphite molds. Additionally, it is within the scope of this invention that contact structures can be mounted to any electronic component, such as the interconnect boards of the assembly embodiments described hereinbelow, or to silicon dies, or the like.

An advantage of the gang-transfer technique of the present invention is that tooling (and costs associated therewith) are minimized (i.e., virtually eliminated), and for any given package configuration, a "template" (not to be confused with the shaped wire stem serving as a template, as mentioned hereinabove) for a given pattern (e.g., array) of resilient contact structures can be specified in a matter of minutes. (Generally, the desired pin layout is already available on CAD software, and a simple "macro" can be invoked to convert array points to a masking pattern for forming the contact areas on the carrier.)

It is within the scope of this invention that, subsequent to gang-transferring a plurality of resilient contact structures to an electronic component (see, e.g., **Figures 7A-7C**), the mounted (to the component) resilient contact structures can be plated or further plated. In other words, (i) a plurality of wire stems which have not been overcoated can be gang-transferred to an electronic component, then overcoated, or (ii) a plurality of wire stems having one or more overcoat layers applied thereto can be gang-transferred to an electronic component, then overcoated with an additional layer of material.

It is also within the scope of this invention that the techniques of gang-transferring a plurality of resilient contact structures to an electronic component can be applied to non-resilient contact structures, such as package pins. In such a case, a plurality of package pins would be fabricated on, or mounted to, a sacrificial substrate for subsequent gang transfer (and, typically, brazing) to an electronic component.

An exemplary process of gang-transferring a plurality of contact structures to an electronic component is described with respect to **Figures 7A-7C**. It is within the scope of this invention that the process is applicable to "regular" contact structures, such as package pins, as well as to the resilient contact structures of the present invention. However, the gang-transfer process is particularly beneficial in the context of the present invention, for the following reasons.

When bonding a wire to a terminal (e.g., on a package), and employing electronic flame off (as would be the case if one were to construct the resilient contact structures of the present invention directly on the package pads), it is possible to generate a spark that will adversely affect a packaged semiconductor device. In many cases, semiconductor devices are mounted in their packages (e.g., ceramic packages) prior to mounting external interconnects to the package. Damage to the semiconductor device at this "late" stage in the process is a costly situation which would best be avoided, if at all possible. The gang-transfer technique of the present invention resolves this issue in a favorable manner, with improved yield.

An additional advantage accruing to fabricating a plurality of contact structures on a sacrificial substrate, then gang-transferring the structures to a package (or to any electronic component) is that the spacing between the contact ends can be controlled. The contact structures can be "originated" on a sacrificial substrate with a first spacing (pitch), and can be fashioned to have a second spacing at their opposite ends. It is within the scope of this invention that contact structures can originate on the sacrificial substrate with a coarse pitch, and can connect to the package (or to any electronic component) at a fine pitch, or vice-versa.

Another advantage accruing to the techniques set forth above is that what will ultimate be the "tips" of the package "pins" (i.e., the contact structures gang-transferred to the package body, or to any electronic component), can be well controlled, not only in their spacing (as discussed in the previous paragraph), but in their shape and topography (in the manner of fabricating probe contact pads, discussed in greater detail hereinabove). By reliably controlling the spacing and disposition of the tips of contact structures on an electronic component, the requirements for fabricating conductive traces, pads, and the like on a substrate (e.g., a printed circuit board) to which the electronic component will be mounted can somewhat be relaxed.

The gang-transfer technique(s) described herein are particularly beneficial for mounting a plurality of contact structures to semiconductor dies, whether singulated or unsingulated. It is within the scope of this invention that contact structures may be fabricated on a sacrificial substrate which are of a sufficient size to gang-transfer a plurality of contact structures to the plurality of unsingulated semiconductor dies on a wafer, at one fell swoop. Alternatively, it is possible to fabricate contact structures on a sacrificial substrate which is the size of a single unsingulated semiconductor die, and to gang-transfer contact structures only to selected "good" dies on the wafer. In either case, the contact structures can be mounted to dies on a wafer prior to dicing (singulating).

In an alternate embodiment of the gang-transfer technique of the present invention, illustrated in **Figure 7D,** a plurality of resilient contact structures are inserted into holes in a package, such as in a plastic package.

**Figure 7D** illustrates the gang transfer of contact structures 1230 (two shown, sacrificial substrate omitted, for illustrative clarity) into recesses 1220 in a surface of an electronic component 1222 such as a plastic package body. The recesses 1220 are filled with a conductive material 1224 which may, for example, be solder which is reflowed, or a conductive epoxy material.

It is within the scope of this invention that the contact structures would not be gang-transferred, rather they would be individually transferred (mounted) to the package, on a one-by-one basis.

It is within the scope of this invention that the gang-transfer technique described hereinabove can be used to form a plurality of probe structures on a probe card, or the like.

A general advantage of the gang-transfer technique of the present invention becomes evident, in contrast to certain prior art techniques of mounting contact structures on semiconductor packages. These prior art techniques involve preparing the package, fabricating pins, feeding the pins one-by-one from a supply ("bucket") of pins and mounting them to the package body with reheating processes. According to the present inventive technique, steps analogous to these are all tied together.

**Figure 7E** illustrates a probe card (board) 1252 which has had a plurality of resilient contact structures 1254 (compare 1230) preferably gang-transferred thereto. (Sacrificial gang transfer substrate (1204) omitted, for illustrative clarity.) The contact structures can be tailored, by their shape and overcoat material, to allow for various levels of overtravel and elasticity. The tips of the contact structures 1254 are topographical, to allow controlled penetration of solder bumps 1256 on an electronic component 1258, said solder bumps having been formed (for example) by the "C-4" process.

As shown in **Figure 7F,** after fabricating a plurality of resilient contact structures (1230), the contact structures can be further overcoated, in the manner described above with respect to **Figure 2G,** to result in a tapered outer layer 1232 of the coating, said outer layer being thicker at the mounted (proximal) end of the contact structure to augment anchoring of the contact structure. This augmented anchoring feature is preferred in the context of probe embodiments, wherein the contact structures are subject to repeated flexing.

Undoubtedly, many other "variations" on the "themes" set forth hereinabove will occur to one having ordinary skill in the art to which the present invention most nearly pertains, and such variations are intended to be within the scope of the invention, as disclosed herein by the set of appended claims.

## Claims

1. A method of mounting a plurality of contact structures to an electronic component, comprising the following steps:
fabricating a plurality of resilient electrical contact structures (1230) on a sacrificial substrate (1204) by
forming the electrical contact structures (1230) from a flexible core material and
overcoating the core material with a material being more resilient than said core material;
bringing the sacrificial substrate into proximity with an electronic component (1252) so that the tips of the electrical contact structures (1230) extending from the sacrificial substrate (1204) contact the electronic component;
in a single step, mounting the electrical contact structures (1230) by their tips to the electronic component; and
after mounting the electrical contact structures (1230) to the electronic component, removing the sacrificial substrate (1204).

2. The method of claim 1, further comprising:
fabricating the electrical contact structure as an interconnection element (1132, 1230, 930) with a contact tip structure (1110, 944) by:
forming the contact tip structure on the sacrificial substrate (1204, 1104, 902);
attaching the interconnection element (1130, 1132, 1230, 912, 914) to the contact tip structure, the interconnection element having a free, tip end suitable for contacting an electronic component.

3. The method according to claim 2, further comprising:
prior to constructing the contact tip structure, providing a selected topography (904) in a selected area of the sacrificial substrate, wherein the contact tip structure is formed on the selected area.

4. The method according to claim 3, further comprising:
providing the selected topography by imposing an articulation in the sacrificial substrate.

5. The method according to claim 3, further comprising providing a selected topography by etching.

6. The method according to claim 3, further comprising providing a selected topography by micromachining.

7. The method according to claim 3, further comprising providing a selected topography by a lithographic process.

8. The method according to claim 3, further comprising providing a selected topography by:
depositing a masking material on the sacrificial substrate;
patterning the masking material to expose selected regions of the sacrificial substrate; and
removing material from the sacrificial substrate in locations according to the patterned masking material.

9. The method according to claim 3, wherein the selected topography includes at least one sharp point.

10. The method according to claim 3, wherein the selected topography includes geometric features on the contact tip structure useful for effecting reliable electrical contact to a terminal of another electronic component when brought into contact with the terminal in a manner expected to effect such contact.

11. The method according to claim 2, further comprising forming the contact tip structure to include a plurality of metallic layers (966, 968, 970, 972).

12. The method according to claim 11, further comprising including in the contact tip structure a surface material (966) which in the finished product will form a contact layer of the contact tip structure.

13. The method according to claim 12, wherein:
the surface material includes a material suitable for making contact with an electronic component.

14. The method according to claim 12, wherein:
the surface material includes a material selected from the list consisting of hard gold and rhodium.

15. The method according to claim 11, further comprising including in the contact tip structure a main tip material (970) to provide strength to the contact tip structure.

16. The method according to claim 15, wherein:
the main tip material includes nickel.

17. The method according to claim 15, wherein:
the main tip material includes a material selected from the list consisting of nickel, cobalt, and iron.

18. The method according to claim 11, further comprising including in the contact tip structure a bonding material (972) for joining to the contact tip structure.

19. The method according to claim 18, wherein:
the bonding material includes a material suitable for bonding to an interconnection element.

20. The method according to claim 18, wherein:
the bonding material includes a material selected from the list consisting of soft gold and hard gold.

21. The method according to claim 1 forming the contact tip structure as part of a cantilevered interconnect structure (930).

22. The method according to claim 2, wherein the interconnection element includes:
an elongate element (912), of the flexible core material; wherein the overcoating material (914) is deposited on the flexible elongate precursor element.

23. The method according to claims 1, wherein:
the overcoating material includes a material selected from the group consisting of nickel and cobalt.

24. The method according to claim 1, wherein:
the core material includes gold.

## Patentansprüche

1. Verfahren zum Montieren einer Vielzahl von Kontaktstrukturen an einem elektronischen Bauteil mit den folgenden Schritten:
Herstellen einer Vielzahl von elastischen elektrischen Kontaktstrukturen (1230) auf einem Opfersubstrat (1204) durch
Ausbilden der elektrischen Kontaktstrukturen (1230) aus einem biegsamen Kernmaterial und
Überziehen des Kernmaterials mit einem Material, das elastischer ist als das Kernmaterial;
Bringen des Opfersubstrats in die Nähe zu einem elektronischen Bauteil (1252), so dass die Spitzen der elektrischen Kontaktstrukturen (1230), die sich vom Opfersubstrat (1204) wegerstrecken, das elektronische Bauteil berühren;
Montieren der elektrischen Kontaktstrukturen (1230) durch ihre Spitzen am elektronischen Bauteil in einem einzelnen Schritt; und
Entfernen des Opfersubstrats (1204) nach dem Montieren der elektrischen Kontaktstrukturen (1230) am elektronischen Bauteil.

2. Verfahren nach Anspruch 1, welches ferner umfasst:
Herstellen der elektrischen Kontaktstruktur als Verbindungselement (1132, 1230, 930) mit einer Kontaktspitzenstruktur (1110, 944) durch:
Ausbilden der Kontaktspitzenstruktur auf dem Opfersubstrat (1204, 1104, 902);
Befestigen des Verbindungselements (1130, 1132, 1230, 912, 914) an der Kontaktspitzenstruktur, wobei das Verbindungselement ein freies Spitzenende aufweist, das zum Kontaktieren eines elektronischen Bauteils geeignet ist.

3. Verfahren nach Anspruch 2, welches ferner umfasst:
Vorsehen einer ausgewählten Topographie (904) in einem ausgewählten Bereich des Opfersubstrats vor der Konstruktion der Kontaktspitzenstruktur, wobei die Kontaktspitzenstruktur auf dem ausgewählten Bereich ausgebildet wird.

4. Verfahren nach Anspruch 3, welches ferner umfasst:
Vorsehen der ausgewählten Topographie durch Vorsehen einer Gliederung in dem Opfersubstrat.

5. Verfahren nach Anspruch 3, welches ferner das Vorsehen einer ausgewählten Topographie durch Ätzen umfasst.

6. Verfahren nach Anspruch 3, welches ferner das Vorsehen einer ausgewählten Topographie durch Mikrobearbeitung umfasst.

7. Verfahren nach Anspruch 3, welches ferner das Vorsehen einer ausgewählten Topographie durch einen lithographischen Prozess umfasst.

8. Verfahren nach Anspruch 3, welches ferner das Vorsehen einer ausgewählten Topographie umfasst, durch:
Abscheiden eines Maskierungsmaterials auf dem Opfersubstrat;
Strukturieren des Maskierungsmaterials, um ausgewählte Bereiche des Opfersubstrats freizulegen; und
Entfernen von Material vom Opfersubstrat an Stellen gemäß dem strukturierten Maskierungsmaterial.

9. Verfahren nach Anspruch 3, wobei die ausgewählte Topographie mindestens einen spitzen Punkt umfasst.

10. Verfahren nach Anspruch 3, wobei die ausgewählte Topographie geometrische Strukturen an der Kontaktspitzenstruktur umfasst, die zum Bewirken eines zuverlässigen elektrischen Kontakts mit einem Anschluss eines anderen elektronischen Bauteils nützlich sind, wenn sie mit dem Anschluss in einer Weise in Kontakt gebracht wird, von der erwartet wird, dass sie einen solchen Kontakt bewirkt.

11. Verfahren nach Anspruch 2, welches ferner das Ausbilden der Kontaktspitzenstruktur so umfasst, dass eine Vielzahl von Metallschichten (966, 968, 970, 972) enthalten sind.

12. Verfahren nach Anspruch 11, welches ferner das Einschließen eines Oberflächenmaterials (966) in die Kontaktspitzenstruktur umfasst, welches im fertiggestellten Produkt eine Kontaktschicht der Kontaktspitzenstruktur bildet.

13. Verfahren nach Anspruch 12, wobei:
das Oberflächenmaterial ein Material umfasst, das zur Herstellung eines Kontakts mit einem elektronischen Bauteil geeignet ist.

14. Verfahren nach Anspruch 12, wobei:
das Oberflächenmaterial ein Material umfasst, das aus der Liste ausgewählt ist, die aus hartem Gold und Rhodium besteht.

15. Verfahren nach Anspruch 11, welches ferner das Einschließen eines Hauptspitzenmaterials (970) in die Kontaktspitzenstruktur umfasst, um der Kontaktspitzenstruktur Festigkeit zu verleihen.

16. Verfahren nach Anspruch 15, wobei:
das Hauptspitzenmaterial Nickel umfasst.

17. Verfahren nach Anspruch 15, wobei:
das Hauptspitzenmaterial ein Material umfasst, das aus der Liste ausgewählt ist, die aus Nickel, Kobalt und Eisen besteht.

18. Verfahren nach Anspruch 11, welches ferner das Einschließen eines Bondmaterials (972) in die Kontaktspitzenstruktur zum Verbinden mit der Kontaktspitzenstruktur umfasst.

19. Verfahren nach Anspruch 18, wobei:
das Bondmaterial ein Material umfasst, das zum Bonden an ein Verbindungselement geeignet ist.

20. Verfahren nach Anspruch 18, wobei:
das Bondmaterial ein Material umfasst, das aus der Liste ausgewählt ist, die aus weichem Gold und hartem Gold besteht.

21. Verfahren nach Anspruch 1, welches die Kontaktspitzenstruktur als Teil einer freitragenden Verbindungsstruktur (930) ausbildet.

22. Verfahren nach Anspruch 2, wobei das Verbindungselement umfasst:
ein langgestrecktes Element (912) aus dem biegsamen Kernmaterial; wobei das Überzugsmaterial (914) auf dem biegsamen langgestreckten Vorstufenelement abgeschieden wird.

23. Verfahren nach Anspruch 1, wobei:
das Überzugsmaterial ein Material umfasst, das aus der Gruppe ausgewählt ist, die aus Nickel und Kobalt besteht.

24. Verfahren nach Anspruch 1, wobei:
das Kernmaterial Gold umfasst.

## Revendications

1. Procédé de montage d'une pluralité de structures de contact sur un composant électronique, comprenant les étapes suivantes :
fabriquer une pluralité de structures de contact électrique élastiques (1230) sur un substrat sacrificiel (1204) par
la formation des structures de contact électrique (1230) à partir d'un matériau de coeur flexible et
le revêtement du matériau de coeur avec un matériau qui est plus élastique que ledit matériau de coeur,
amener le substrat sacrificiel jusqu'à proximité d'un composant électronique (1252) de sorte que les pointes des structures de contact électrique (1230) s'étendant depuis le substrat sacrificiel (1204) entrent en contact avec le composant électronique,
en une seule étape, monter les structures de contact électrique (1230) par leurs pointes sur le composant électronique, et
après le montage des structures de contact électrique (1230) sur le composant électronique, éliminer le substrat sacrificiel (1204).

2. Procédé selon la revendication 1, comprenant en outre :
la fabrication de la structure de contact électrique en tant qu'élément d'interconnexion (1132, 1230, 930) avec une structure de pointe de contact (1110, 944) par :
la formation de la structure de pointe de contact sur le substrat sacrificiel (1204, 1104, 902),
la fixation de l'élément d'interconnexion (1130, 1132, 1230, 912, 914) à la structure de pointe de contact, l'élément d'interconnexion comportant une extrémité de pointe libre convenant à une mise en contact d'un composant électronique.

3. Procédé selon la revendication 2, comprenant en outre :
avant la construction de la structure de pointe de contact, la fourniture d'une topographie sélectionnée (904) dans une zone sélectionnée du substrat sacrificiel, dans lequel la structure de pointe de contact est formée sur la zone sélectionnée.

4. Procédé selon la revendication 3, comprenant en outre :
la fourniture de la topographie sélectionnée en appliquant une articulation dans le substrat sacrificiel.

5. Procédé selon la revendication 3, comprenant en outre la fourniture d'une topographie sélectionnée par gravure.

6. Procédé selon la revendication 3, comprenant en outre la fourniture d'une topographie sélectionnée par micro-usinage.

7. Procédé selon la revendication 3, comprenant en outre la fourniture d'une topographie sélectionnée par un procédé de lithographie.

8. Procédé selon la revendication 3, comprenant en outre la fourniture d'une topographie sélectionnée par :
le dépôt d'un matériau de masquage sur le substrat sacrificiel,
la mise en motif du matériau de masquage pour exposer des régions sélectionnées du substrat sacrificiel, et
l'élimination du matériau du substrat sacrificiel dans des emplacements conformes au matériau de masquage mis en motif.

9. Procédé selon la revendication 3, dans lequel la topographie sélectionnée comprend au moins une pointe acérée.

10. Procédé selon la revendication 3, dans lequel la topographie sélectionnée comprend des éléments géométriques sur la structure de pointe de contact utiles à la réalisation d'un contact électrique fiable avec une borne d'un autre composant électronique lorsqu'ils sont amenés jusqu'en contact avec la borne d'une manière prévue pour réaliser un tel contact.

11. Procédé selon la revendication 2, comprenant en outre la formation de la structure de pointe de contact de manière à inclure une pluralité de couches métalliques (966, 968, 970, 972).

12. Procédé selon la revendication 11, comprenant en outre l'inclusion dans la structure de pointe de contact d'un matériau de surface (966) qui formera dans le produit fini une couche de contact de la structure de pointe de contact.

13. Procédé selon la revendication 12, dans lequel :
le matériau de surface comprend un matériau convenant pour établir un contact avec un composant électronique.

14. Procédé selon la revendication 12, dans lequel :
le matériau de surface comprend un matériau sélectionné à partir de la liste constituée d'or dur et de rhodium.

15. Procédé selon la revendication 11, comprenant en outre l'inclusion dans la structure de pointe de contact d'un matériau principal de pointe (970) pour communiquer de la résistance à la structure de pointe de contact.

16. Procédé selon la revendication 15, dans lequel :
le matériau principal de la pointe comprend du nickel.

17. Procédé selon la revendication 15, dans lequel :
le matériau principal de la pointe comprend un matériau sélectionné à partir de la liste constituée du nickel, du cobalt et du fer.

18. Procédé selon la revendication 11, comprenant en outre l'inclusion dans la structure de pointe de contact d'un matériau de liaison (972) destiné à établir une jonction sur la structure de pointe de contact.

19. Procédé selon la revendication 18, dans lequel :
le matériau de liaison comprend un matériau convenant pour une liaison avec un élément d'interconnexion.

20. Procédé selon la revendication 18, dans lequel :
le matériau de liaison comprend un matériau sélectionné à partir de la liste constituée d'or mou et d'or dur.

21. Procédé selon la revendication 1, formant la structure de pointe de contact en tant que partie d'une structure d'interconnexion en porte-à-faux (930).

22. Procédé selon la revendication 2, dans lequel l'élément d'interconnexion comprend :
un élément allongé (912) du matériau de coeur flexible, dans lequel le matériau de revêtement (914) est déposé sur l'élément précurseur allongé flexible.

23. Procédé selon la revendication 1, dans lequel :
le matériau de revêtement comprend un matériau sélectionné à partir du groupe constitué du nickel et du cobalt.

24. Procédé selon la revendication 1, dans lequel :
le matériau de coeur comprend de l'or.
